# EUROPEAN PATENT SPECIFICATION

(11) **EP 3 797 304 B1**
(45) Date of publication and mention of the grant of the patent: **04.10.2023**
(21) Application number: 19708957.6
(22) Date of filing: 18.02.2019
(51) Int. Cl.: G01R 23/20, G01R 23/16, G01R 31/34, H02H 3/52, H02H 7/08

(54) **SYSTEM AND METHOD FOR MONITORING AN OPERATING CONDITION OF AN ELECTRICAL DEVICE WHEN IN OPERATION**
SYSTEM UND VERFAHREN ZUR ÜBERWACHUNG EINES BETRIEBSZUSTANDES EINES ELEKTRISCHEN GERÄTES IM BETRIEB
SYSTÈME ET PROCÉDÉ PERMETTANT DE SURVEILLER UN ÉTAT DE FONCTIONNEMENT D'UN DISPOSITIF ÉLECTRIQUE EN FONCTIONNEMENT

(30) Priority: 18.02.2018 GB 201802619
(43) Date of publication of application: 31.03.2021
(73) Proprietor: Faraday Predictive Limited, Cambridge Cambridgeshire CB4 0WS (GB)
(72) Inventor: BATES, ANDREW, Baltonsborough BA6 8QY (GB); BOULTON, William, Cambridge Cambridgeshire CB1 2QF (GB); BANNISTER, Myles, Cranbrook Kent TN17 2HL (GB); ALFEIRAN, Bran, 08003 Barcelona (ES); WALKER, Geoffrey, Tunbridge Wells Kent TN3 0BA (GB)
(74) Representative: Basck Limited
(86) International application number: PCT/EP2019/053964
(87) International publication number: WO 2019/158751

(56) References cited:
- US-A- 4 761 703
- US-A- 5 629 870
- US-A1- 2006 071 666
- US-A1- 2017 016 960

## Description

### TECHNICAL FIELD

The present disclosure relates generally to monitoring electrical devices, and more specifically, to a system and method for (of) monitoring an operating condition of an electrical device when in operation. Moreover, the present disclosure also relates to a computer program product comprising a non-transitory computer-readable storage medium having computer-readable instructions stored thereon, the computer-readable instructions being executable by a computerized device comprising processing hardware to execute the aforesaid method. Embodiments of the present disclosure concern a type of technology that is capable of reducing Carbon Dioxide (CO₂) emissions, as a result of improving operation of electrical devices, for example electrical machines, at higher efficiency and avoiding unnecessary maintenance.

### BACKGROUND

An example electrical device transforms electrical energy, defined by electrical current and voltage, into another form of energy, for example light energy, heat energy, or motional (kinetic) energy (e.g. an electrical motor) or *vice versa* (e.g. an electrical generator). Alternatively, an electrical device (e.g. a transformer) may transfer or couple electrical energy from one circuit to another. In industrial applications, large numbers of such electrical devices are employed. These electrical devices have to be periodically monitored manually or by using monitoring systems to detect unexpected faults that can halt or hamper operation, for example production; such monitoring is performed, for example, proactively. A cumulative annual expenditure of $700 billion can be attributed either to faults in electrical equipment or their maintenance, wherein the expenditure includes additional damage, corrective work, and other consequential impacts.

When a fault occurs in a given electrical device, an electrical power consumption of the given electrical device in a faulty condition potentially differs from an electrical power consumption of the given electric device under corresponding conditions prior to occurrence of the fault condition. For example, in a case of an assembly having an electric motor, failure or deterioration in a condition of the electrical motor may bring about either an increase or a decrease in the power consumption of the electrical motor, depending upon a nature of the failure. Changes in conditions other than failures or deterioration of the electrical motor may also potentially affect the power consumption of the electrical motor. For example, a change in a load experienced by the electrical motor may affect its power consumption.

Existing known monitoring systems and methods that are employed for monitoring electrical devices are cumbersome, expensive, and/or are limited to identifying only a few failure modes of the electrical devices. Furthermore, the existing monitoring systems and methods are inaccurate in prognosing and/or diagnosing, potential problems or faults. One such existing known monitoring system employs a vibration analysis, which is used to detect faults in rotating equipment (e.g., fans, motors, pumps, gearboxes etc.) such as imbalance, misalignment, rolling element bearing faults, and resonance conditions. Another existing known monitoring system employs an electrical motor current signature analysis (MCSA) that measures current on a single electrical phase or three electrical phases of an electrical motor to monitor an operating condition of the electrical motor. However, this existing known system is not capable of analyzing distorted voltages and has a limited fault-type application.

Known model-based voltage and current (MBVI) systems are inflexible, have limited diagnostic capability and provide a high level of false alerts, resulting in a need for expert interpretation of their outputs. Furthermore, known model-based voltage and current (MBVI) systems are too difficult to deploy due to their inflexible connection and configuration abilities. Such a combination of high costs for typical model-based voltage and current (MBVI) systems, installation challenges, and the cost of expert interpretation render them too expensive for widespread adoption.

Therefore, in light of the foregoing drawbacks and problems encountered with known monitoring systems, there exists a need to overcome the aforementioned drawbacks in existing known systems and methods used for monitoring an operating condition of an electrical device.

In a published European patent application EP2725370A1; "A method for the diagnostics of electromechanical system based on impedance analysis"; inventors Ottewill (GB), Orman (PL) and Pinto (IN); applicant ABB Technology AG (DE); there is described a method for diagnosing a state of electromechanical systems in which electrical rotating machinery is used, wherein the method employs an analysis of impedance estimated from at least two currents and two voltages, measured during an operation of the electromechanical system. The method is potentially useful when performing condition monitoring of electric motors and generators. The method includes combining such information from both the voltage and current signals measurable at the motor terminals. Specifically, the measurements of voltage and current from two or more phases of a polyphase electrical machine are combined to estimate an impedance of the machine, wherein the impedance is a resistance to the flow of current that a circuit exhibits when a voltage is applied thereto.

In a published granted US patent US6308140B1; "Motor condition and performance analyzer"; inventors Dowling (US), Lang (US), Desai (US) and Ricciuti (US); applicant Crane Nuclear Inc.; there is described a method of detecting broken rotor bars, wherein the method includes sensing currents applied to a motor, converting the sensed currents to digital data signals, and storing the digital data signals. A processor evaluates the digital data to provide a current signal spectrum at various selected sidebands. Sideband peaks having an amplitude within a predetermined value are identified, indicating potential motor problems or developing problems, including winding faults and broken rotor bars. Advanced signal processing techniques are used to evaluate further stored data and to provide trending information.

In a published PCT application WO2017/075254A1; "Interior magnet machine design with low core losses"; Campbell (US) and Dang (US); applicant Faraday & Future Inc. (US); there are described methods and apparatus for estimating and minimizing core losses in interior magnet machines. Such methods, for example, include creating, modifying, or receiving a finite element analysis (FEA) model to represent at least one portion of a motor in a computer system, placing at least one coil at a first location within a rotor iron or stator iron of the motor in the FEA model, calculating a time-domain flux density B of the at least one coil, converting the calculated flux density function to a frequency-domain spectrum, receiving material core loss parameters for at least some frequencies indicated by the frequency-domain spectrum, and determining a core loss of the at least one portion of an electric motor by a weighted combination of the material core loss parameters. Coils are placed, for example, manually by a user through a user interface, or are placed automatically.

In a published US patent US4761703A; "Rotor fault detector for induction motors"; assigned to Electric Power Research Institute Inc.; there is described a method and apparatus for detecting rotor faults in an induction motor. A flux sensor generates a flux signal corresponding to the magnetic flux at a predefined flux detection point external to the motor. A current sensor generates a current signal proportional to the current drawn by said motor. A time series of data points is stored, representing the values of the flux signal and the current signal over a period of time. The time series are transformed by FFT into a set of flux spectra and into a set of current spectra. Then the line frequency of the motor's power supply is determined by finding the maximum of the current spectra. Similarly, the slip frequency of the motor is determined by finding the maximum of the flux spectra in a predefined spectral range (e.g., below 2 Hz). The analysis of the rotor is then performed by comparing the amplitude of the current spectra, at a set of rotor fault harmonic frequencies, with specified fault threshold criteria. Each rotor fault harmonic frequency is a predefined function of the line frequency and the slip frequency. The presence of a rotor fault is denoted if the amplitude of any of said current spectra exceed a corresponding fault threshold criteria.

In a published US patent US5629870A; "Method and apparatus for predicting electric induction machine failure during operation"; assigned to Siemens Industry Inc.; there is described a method and apparatus for identifying in real time an operating condition of an in-service electrical device which draws a power load by monitoring spectral content of the power signature and associating spectral components with device operating conditions. In the preferred embodiment, motor power line current signature is sampled by data conditioning sampler. Preprocessor spectrally separates the current signature into plural frequency domain components having respective frequency and magnitude values. Spectral characteristic component selector filter selects for analysis at least one specific spectral component by referencing a base of stored knowledge of operational characteristics of the motor. A neural network associates without supervision the selected detected spectral component with an operating condition of the motor. The base of stored knowledge is updated with new operating condition associations which have been made during real-time monitoring. A post processor may enunciate the association to a user via an output device and it may generate a control signal to operate electrical distribution system protection or control apparatus.

In a published US patent US2006071666A1; "Detection of pump cavitation/blockage and seal failure via current signature analysis"; assigned to Rockwell Automation Technologies Inc.; there is described a system and method for monitoring the operating condition of a pump by evaluating fault data encoded in the instantaneous current of the motor driving the pump. The data is converted to a frequency spectrum which is analyzed to create a fault signature having fault attributes relating to various fault conditions associated with the pump. The fault signature is then input to a neural network that operates in conjunction with a preprocessing and post processing module to perform decisions and output those decisions to a user interface. A stand alone module is also provided that includes an adaptive preprocessing module, a one-shot unsupervised neural network and a fuzzy based expert system to provide a decision making module that operates with limited human supervision.

### SUMMARY

Embodiments of the present disclosure seek to provide an improved system and method that can be used for monitoring an operating condition of an electrical device.

The present disclosure provides an electrical condition monitoring system as defined in the independent claim 1. Further embodiments are defined in the corresponding dependent claims 2-16.

The invention is of advantage in that removal of effects of signal distortion enables an operating state of the electrical device to be determined more accurately and reliably.

The present disclosure also provides a method of using the electrical condition monitoring system of the invention; the method being defined by the independent claim 17.

The present disclosure also provides a computer program product comprising a non-transitory computer-readable storage medium having computer-readable instructions stored thereon to cause the system of claim 1 to execute all the steps of the method of claim 17.

Embodiments of the present disclosure substantially eliminate, or at least partially address, the aforementioned drawbacks in existing known systems and methods used for monitoring an operating condition of an electrical device.

Additional aspects, advantages, features and objects of the present disclosure are presented by the drawings and the detailed description for the better understanding of the embodiments of the invention defined by the appended claims.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIG. 1 is a schematic illustration of an electrical condition monitoring system in accordance with an embodiment of the present disclosure;
FIG. 2 is a functional block diagram of a data processing arrangement in accordance with an embodiment of the present disclosure;
FIG. 3 is an exemplary view of a graphical user interface of an electrical condition monitoring system in accordance with an embodiment of the present disclosure;
FIG. 4 is an exemplary view of a graphical user interface of an electrical condition monitoring system that depicts operating conditions of an electrical device in accordance with an embodiment of the present disclosure;
FIG. 5 is an exemplary view of a graphical user interface of an electrical condition monitoring system that depicts an identification of peaks in a temporally-changing Fourier spectrum in accordance with an embodiment of the present disclosure;
FIG. 6 is an exemplary view of a graphical user interface (GUI) of an electrical condition monitoring system that depicts suggestions to a fault detected in an electrical device (e.g. a belt drive) in accordance with an embodiment of the present disclosure;
FIG. 7 is an exemplary view of a graphical user interface (GUI) of an electrical condition monitoring system that depicts automatic identification and operating condition of a rotor bar in accordance with an embodiment of the present disclosure;
FIG. 8 is an exemplary view of a graphical user interface (GUI) of an electrical condition monitoring system that depicts automatic identification of energy wastage in an electrical device in accordance with an embodiment of the present disclosure;
FIGS. 9A and 9B are exemplary tabular views that depict detection of faults in an electrical device using an electrical condition monitoring system in accordance with an embodiment of the present disclosure; and
FIGS. 10A to 10E are flow diagrams illustrating a method in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

The present disclosure provides an electrical condition monitoring system that is connectable to an electrical device, and that is configured to monitor the electrical device when the electrical device is in operation, wherein:
(i) the electrical condition monitoring system includes a sensing arrangement for temporally sensing an electrical supply to and/or from the electrical device and generating corresponding sensed data by processing the sensed electrical supply to and/or from the electrical device, wherein the sensed data includes information associated with at least one of a supply of voltage or a supply of current to and/or from the electrical device;
(ii) the electrical condition monitoring system includes a data processing arrangement including a data processor that is configured to process the sensed data to generate a corresponding temporally-changing Fourier spectrum including signal harmonic components for at least one of the current or the voltage that is supplied to and/or from the electrical device (optionally, and/or a calculated residual current or a calculated residual voltage, wherein a calculated residual current is calculated by comparing a model of predicted current with a measured current of the electrical device to generate residual current data); and to process temporal changes in magnitudes and frequencies of the signal harmonic components to generate analysis data representative of operation of the electrical device; and
(iii) a user interface is configured for user entry of input for analyzing the analysis data and the data processor is configured to analyze the analysis data based on the input to obtain information indicative of an operating condition of the electrical device;
characterized in that:
(iv) the data processing arrangement is operable to at least partially filter out the changes in magnitudes and frequencies of the signal harmonic components caused due to electrical distortion present in the temporally-changing Fourier spectrum;
(v) the data processing arrangement is operable to identify at least one local maximum corresponding to a phenomenon on the temporally-changing Fourier spectrum by analyzing the temporally-changing Fourier spectrum that are plotted based on the sensed data;
(vi) the data processing arrangement is operable to calculate locations on the temporally-changing Fourier spectrum where the same phenomenon appears to create a family of possible local maxima;
(vii) the data processing arrangement is operable to identify a significant local maximum from the family of possible local maxima corresponding to the phenomenon and to generate the analysis data from a magnitude of the significant local maximum;
(viii) the data processing arrangement is operable to generate a real-time model of the electrical device based on the analysis data; and
(ix) the data processing arrangement is operable to access one or more stored models of operation of the electrical device, and to compare the real-time model with the one or more stored models to generate information indicative of an operating condition of the electrical device.

The present system thus monitors the operating condition of the electrical device (e.g. a "health" of the electrical device) more accurately than existing known monitoring systems, over a period of time. The present system helps to avoid performing unnecessary maintenance works on the electrical device. The present system can analyze problems or faults that are developing in the electrical device before they become critical and provide suggestions to solve the problems or faults at a suitable time to avoid unexpected breakdowns of the electrical device.

Optionally, the electrical device is an electrical power-consuming device. Alternatively, the electrical device is an electrical power-generating device. Yet alternatively, the electrical device is capable of functioning as an electrical power-consuming device and an electrical power-generating device; for example. The electrical device, when in operation, is capable of functioning temporally alternately as an electrical power-consuming device and an electrical power-generating device, for example a turbine generator of a water reservoir used for energy storage, wherein power is generated by the turbine generator when water is release from the reservoir via the turbine generator, and wherein power is stored by the turbine generator when water if pumped upwards against gravity into the reservoir. Similar considerations pertain, *mutatis mutandis* where the reservoir is substituted for a compressed-air energy storage reservoir, a tidal water reservoir, and an inertial flywheel energy storage and generating device, a vehicle electrical motor and regenerative braking system, and so forth. By *"vehicle"* includes one or more of road vehicles, railway vehicles, ships, ferries, submarines, aircraft employing electric-motor propellers and so forth.

The present system thus manages to process at least one of current or voltage measurements, or both, having distortion and infer the sensed data from measured voltage or current signals, or both, despite the voltage and current signals are being distorted, for effectively monitoring the operating condition of the electrical device. The present system is more reliable than the aforesaid existing known monitoring systems in detection of problems or faults in the electrical device, thereby avoiding false alarms which can be very disruptive and costly to an industrial facility using the electrical device (e.g. an electrical motor, an electrical generator and so forth). Furthermore, the present system can be easily connected with the electrical system including such an electrical device, and may not require any configurational changes in the electrical device to be made when deploying the present system. The present system helps to save a maintenance cost of the electrical device to a larger extent than hitherto feasible by adopting a condition-based maintenance strategy for the maintenance of the electrical device.

The present system can reduce, for example minimize, energy wastages by promptly analyzing the problems in the electrical device in real-time and by quantifying benefits based on information associated with energy wastages occurred in the electrical device. The present system can generate a baseline profile (e.g. a capability of acceptance of the sensed data, a lifetime of the electrical device etc.) of the electrical device at a Factory Acceptance Test (FAT). The present system may perform a subsequent test (e.g. a Post-Installation Test (PIT) or a commissioning test) on the electrical device on commissioning thereof to confirm that no damage has occurred during delivery and installation processes of the electrical device. The present system may generate automatic written suggestions and graphical reports (e.g. analysis data) that can be edited by a user through the user interface (for example, a graphical user interface (GUI)) to add any specific information. The present system may provide the analysis data to a concerned person (e.g. to a maintenance team or a maintenance manager), whoever the user chooses.

The present system helps, for example, to monitor operating conditions of inaccessible electrical devices such as a submerged pump, a borehole pump, an in-tank pump, a cryogenic pump and a roof mounted fan, a remote unmanned hydroelectric generator, a remote unmanned wind-turbine, a remote unmanned tidal turbine, and remote unmanned wave-energy turbine, a heliostat turbine electrical generator, etc. The present system may help to monitor or test an operating condition of a given electrical device without requiring shutting down or requiring access to the inside of a cabinet of the electrical device in some circumstances. The present system can automatically analyze faults present in the electrical device and provide suggestions on a nature of the faults, a corrective action required and a timescale in which the corrective action should be taken based on measurements of:
(i) the voltage or the current, or both, supplied to the electrical device; or
(ii) the voltage or the current, or both, generated by the electrical device in case of a generator.

The present system can also monitor the electrical devices while the electrical devices are operating at different speeds and different loads.

The electrical condition monitoring system can identify a wide range of failure modes and assess a degree to which the electrical device is suffering from the failures by generating the sensed data based on the voltage or current, or both, drawn by and/or supplied from the electrical device when in operation. In an embodiment, the electrical condition monitoring system is portably connected to the electrical device (e.g. an electrical motor and/or an electrical generator) to measure the voltage or the current, or both, that are being drawn to the electrical motor when in operation and/or generated from the electrical generator when in operation. The electrical condition monitoring system may periodically measure the voltage or the current, or both, supplied to and/or supplied from the electrical device for monitoring the operating condition of the electrical device.

The sensing arrangement may efficiently measure the voltage or the current, or both, supplied to and/or supplied from the electrical device that is operating at different speeds and different loads. The sensing arrangement may include current clamps to measure the current and dolphin connectors or magnetic connectors to measure the voltage to the electrical device. In an embodiment, the electrical condition monitoring system is electrically connected to the electrical device for temporally sensing the electrical supply to the electrical device using the sensing arrangement. The sensing arrangement may filter and process the electrical supply (e.g. the supply of voltage and/or the supply of current) to the electrical device and generate the corresponding sensed data.

The electrical condition monitoring system may generate the temporally-changing Fourier spectrum for at least one of the current or the voltage (optionally, or a calculated residual current or residual voltage), by performing a Fast Fourier Transform (FFT), or a similar type of signal spectral transformation, on at least one of the current and the voltage that is supplied to and/or supplied from the electrical device (optionally, or a calculated residual current or a calculated residual voltage). The analysis data may include a trend graph showing the changes in magnitudes and frequencies of the signal harmonic components based on the sensed data; optionally, the trend graph may also show non-harmonic signal components of a stochastic or random nature. The analysis data may include a report that indicates an operating condition of the electrical device. The analysis data may be generated in .ppt format, .doc format, XML^{®} format etc. In an embodiment, the electrical condition monitoring system generates analysis data in a convenient format such as Microsoft Word^{®} that provides a range of information including raw data (e.g. voltage and current waveform of the sensed signals, a diagnosis, a prognosis, information on the fault and recommended action). In an embodiment, the outputs may include a trend graph, information related to at least one of generic or specific faults detected in the electrical device, suggestions for faults detected in the electrical device, an operating condition of the electrical device in different time periods, energy wastage occurred due to the faults in the electrical device.

In an embodiment, the electrical condition monitoring system retrieves information pertaining to parameters of the electrical device (e.g. an electrical motor, an electrical power inverter, an electrical linear actuator, an electrical generator) from a database of the electrical condition monitoring system when the electrical device is previously tested by the electrical condition monitoring system. The parameters may include nominal voltage, nominal current and nominal speed that is taken from the electrical device. The electrical condition monitoring system may generate an automated report for the electrical device that includes at least one of: imbalance or misalignment, bearing problems, foundation looseness, transmission looseness or rubbing, motor rotor bars, motor stator problems, generator rotor bars, generator stator problems, electrical odd harmonics or other spectrum peak beyond normal expected values, stochastically varying information (e.g. arising from sporadic electrical insulation breakdown). The electrical condition monitoring system may generate a report that includes information on electrical parameters associated with the electrical device which include at least one of active power, reactive power and power factor, voltage balance, current balance, total harmonic distortion (THD) in the voltage or THD in the current.

In an embodiment, the electrical distortion may include for example distortion caused due to switching noise, non-linearity noise (e.g. magnetic saturation noise), spark discharge noise, present in the temporally-changing Fourier spectrum, distortion caused due to an operation of the electrical device, distortion caused due to variations in motor current or generator current caused by variations in the electrical device behaviours or distortion caused due to induced noise coming from other electrical devices/equipments.

In an embodiment, the trend graph is displayed either as the magnitude of a specific line frequency (e.g. the magnitude of 40 Hertz (Hz) peak) or the magnitude of a highest peak or local maximum in the family of locations corresponding to the same underlying phenomenon (e.g. a 10 Hz phenomenon occurring in the electrical device that is fed by, and/or generates, a supply with a frequency of 50Hz may show up on the temporally-changing Fourier spectrum at either 40Hz (50-10) or 60 Hz (50+10)). Sometimes it may also appear as sidebands on higher harmonics of line frequency, such as 90 Hz or 110Hz (i.e. 2*50 Hz +/- 10 Hz), at 140 Hz or 160 Hz (i.e. 3*50 Hz +/- 10 Hz) or at 190 Hz or 210 Hz (i.e. 4*50 Hz +/- 10 Hz)) etc. The trend graph may be plotted based on a highest peak in such a family of peaks. In an embodiment, when identifying the highest peak or local maximum in the family of possible peaks or local maxima, the magnitude of the highest peak may be determined based on either the absolute magnitude of the highest peak, or the magnitude relative to a height of that peak during the base-lining process or the magnitude relative to an average from a number of other electrical devices that is being used for comparison purposes. The magnitude of the highest peak may be calculated either on absolute numbers or a number of standard deviations.

In an embodiment, the data processing arrangement identifies the at least one local maximum corresponding to a phenomenon on the temporally-changing Fourier spectrum by applying well-established rules (e.g. 1X rotational speed is an indicator of imbalance or eccentricity and 2X supply frequency is an indicator of stator winding problems). In an embodiment, a location on the temporally-changing Fourier spectrum at which the at least one local maximum appears is *m*fₗ +/- *n*fₚ, where fₗ is a line frequency and fₚ is frequency of the phenomenon of interest and *m* and *n* are integers. In an embodiment, any particular phenomenon provides local maxima on either side of the line frequency and/or on harmonics of the line frequency. It will be appreciated that the data processing arrangement is operable to identify potential faults depending upon whether *m* and *n* are indicative of odd or even harmonics.

In an embodiment, the electrical condition monitoring system employs a change-point technique (e.g. a Cumulative Sum (CUSUM) algorithm) to identify changes in the parameters of the electrical device (e.g. a nominal voltage, a nominal current and a nominal speed). The voltage and current signals can be noisy from many reasons, for example due to the electrical switching noise, namely a form of signal distortion. However, it will be appreciated that unexpected magnetic saturation can also potentially give rise to signal distortion, that the electrical condition monitoring system is capable of detecting. The change-point technique is a technique that is typically used for monitoring change detection. The change-point technique may help the electrical condition monitoring system to detect 1% change in a mean of the voltage and current signals which is varying by +/-50% or so. Optionally, for example, the change-point technique may help the electrical condition monitoring system to detect up to a 5% change in a mean of the voltage and current signals which is varying in a range of +/-10% by +/-50%.

The electrical condition monitoring system may generate the trend graph (i.e. the analysis data) by employing a curve fitting process on the trend graph which is derived from the aforementioned temporally-changing Fourier spectrum. The curve fitting process (e.g. a spline curve fit, but not limited thereto) refers to a process of constructing a curve, or mathematical function, that has the best fit to a series of data points, optionally subject to constraints. In an embodiment, the trend graph is extrapolated using a curve fitting technique (e.g. linear, parabolic or exponential) for future purpose.

The electrical condition monitoring system may determine the change-point technique and the curve fitting process to be employed based on normalized sets of data associated with different loads and different speeds. The process of determining the change-point technique and the curve fitting process is very complex; moreover, it is also very sensitive to the load. For example, if the load of the electrical device is changed, the current supplied to the electrical device can be changed without changing the supply of voltage. Thus, parameter values of the linear models are sensitive to changes in the load and speed, as aforementioned. As the parameter values of the linear models are used to identify the problems inside the electrical device (e.g. electrical motor and driven equipment or the generator and driver equipment) or in the electrical supply, the electrical condition monitoring system has less tendency to generate false alerts (for example, avoids generating false alerts), if the change is due to the load or speed of the electrical device. The electrical condition monitoring system may compare the parameter values of the linear model or stored model with parameter values of a real-time model to determine the expected parameter values at a particular load and speed. The electrical condition monitoring system compares the parameter values by creating a set of individual cells and each cell corresponds to a particular range of load and speed (e.g. frequency is 40 Hz to 45 Hz and the supply of current is in a range of 100 Amperes to 110 Amperes). During a baseline process which is generally carried out after initial installation and commissioning of the electrical device, each time a set of sensed data is taken, their results are updated in their corresponding cell. In an embodiment, the electrical condition monitoring system determines characteristics of a relationship between the parameter values and the load and speed of the electrical device. The electrical condition monitoring system uses the characteristics of the relationship to assess an expected parameter value for a measured load and speed of the electrical device, without having to have previously populated data in this particular cell.

According to an embodiment, the data processing arrangement computes parameter differences between the real-time model and the one or more stored models, and to generate a predictive model describing the parameter difference to generate the information indicative of an operating condition of the electrical device. According to another embodiment, the data processing arrangement generates from the predictive model one or more alerts relating to: one or more energy utilization trends of the electrical device; Carbon Dioxide (equivalent) generation being caused by the electrical device; Carbon Dioxide (equivalent) generation being saved by the electrical device; and maintenance, replacement or repair of the electrical device.

According to yet another embodiment, the user interface (e.g. a graphical user interface (GUI)) is configured for user entry of user defined parameters for generating a range of multivariate cells in a database of the electrical condition monitoring system and the data processing arrangement is configured to update the sensed data of the electrical device in their respective multivariate cells, wherein the multivariate cells store the temporally-changing Fourier spectrum associated with the sensed data and the one or more stored models associated with the electrical device.

The sensed data may include both the parameter values and the magnitudes of the local maxima and local minima on the temporally-changing Fourier spectrum. A large set of sensed data are taken and each sensed data is updated to the values in their respective multivariate cells to generate an updated average and a standard deviation for the sensed data, which is further updated with each new sensed data; by *"large"* is meant in a range of 2 to 100000 separate readings, more optionally in a range of 50 to 500 readings. The electrical condition monitoring system may compare the new sensed data with the mean values in the appropriate multivariate cell once the baseline process is completed. The electrical condition monitoring system may quantify the parameter difference in terms of the number of standard deviations in the multivariate cells. In order to update the new sensed data occurring at a combination of the load and the speed and that has not previously had a multivariate cell, the electrical condition monitoring system may use a process of interpolation and extrapolation from the multivariate cells to identify where the sensed data is stored in the multivariate cells and where there is no previous data. In an embodiment, the electrical condition monitoring system characterizes a way that the parameters vary across the multivariate cells (e.g. imagine a 3-dimensional surface (*"surface"* in claims below) drawn over a matrix of voltage and current) and estimates the expected values in the multivariate cell on the basis of obtaining actual sensed data in only a small number of the multivariate cells.

According to yet another embodiment, the data processing arrangement is configured to, namely *"operates to"* when in operation, update pre-existing analysis data in their respective multivariate cells with the analysis data to generate an updated average and a standard deviation for the sensed data. According to yet another embodiment, the data processing arrangement is configured to, namely *"operates to"* when in operation, decimate data points in the sensed data based on calculated frequency to determine a number of relevant data points for generating the temporally-changing Fourier spectrum. In an embodiment, the temporally-changing Fourier spectrum are plotted to line up perfectly when plotted in terms of orders and when different samples occurred at widely different supplied frequencies; *"perfectly"* in such a context means that the points on each spectrum will line up with one another, when individual spectra associated with variable speed machines, created at different supply frequencies and therefore different equipment speeds, have to be either stretched or compressed along the frequency axis in order for corresponding features to line up.

According to yet another embodiment, the electrical device includes at least one of: a synchronous 1-phase electrical motor, a synchronous multi-phase electrical motor, a synchronous 3-phase electrical motor, a switched reluctance motor, a switched stepper motor, a D.C. electrical motor, a compressor, a pump, a fan, a conveyor, an agitator, a blender, a blower, a mixer, a Permanent Magnet (PM) motor, a PM generator, a power transformer, an air conditioner, a ventilator, an oven, a solar panel, an electromagnetic linear actuator, an electromagnetic linear generator, a light source for illumination, a synchronous 1-phase electrical generator, a synchronous multi-phase electrical generator, a synchronous 3-phase electrical generator, a D.C. electrical generator, a Permanent Magnet (PM) generator. However, it will be appreciated that embodiments of the present disclosure can be used to monitor other types of electrical devices, for example industrial microwave ovens (e.g. to detect electrode erosion or vacuum degradation), resistive heating element ovens (e.g. to detect heating element progressive oxidation or heating element micro-cracking), solar cell generating performance (e.g. condensation, element ageing, solar cell cracking). According to yet another embodiment, the user interface is configured for user entry of machine parameters describing the electrical device, wherein the machine parameters include at least one of: generic nominal operating voltage, generic nominal operating current, generic nominal supply frequency, generic nominal rotational speed, number of vanes on an impeller of the electrical device, bearing type codes of the electrical device or belt drive dimensions of the electrical device.

According to yet another embodiment, the user interface is configured for user entry of machine parameters describing analysis type to be executed by the data processing arrangement, wherein the analysis type allows user-setting of temporal resolution and a sensing data sample length. According to yet another embodiment, the user interface allows user setting of voltage and/or current readings from the electric device at a sample rate of up to at least 2 MegaHertz (2 MHz) to 10 MegaHertz (10 MHz).

Optionally, sample rates of 100 KHz are employed, decimated into a selectable frequency range of 2.5 kHz to 25 kHz. However, it will be appreciated that the sample rate accommodated is optionally up to 1 MHz. Yet more optionally, the sampling rate is in a range of 2.5 kHz to 125 MHz, for example selectable within this range.

According to yet another embodiment, the user interface allows user-selection for implementing D-Q phase and A-B phase transformations, computed in the data processing arrangement, of the sensed data, wherein the D-Q phase transformation transfers three-phase stator and rotor quantities into a single rotating reference frame to eliminate an effect of time-varying inductances, wherein the A-B phase transformation refers to a mathematical transformation that is implemented to simplify the analysis of three-phase stator and rotor. According to yet another embodiment, the data processing arrangement is configured to create a linear model of one or more relationships between voltage and current signals obtained from the electrical device; for example, various spline fits to sample data can be employed for the one or more relationships.

According to yet another embodiment, the data processing arrangement is configured to compute an analysis of at least one of a numerical algorithm for Sub-Space State-Space System Identification (N4SID), a Multivariable Output Error State Space (MOESP) algorithm, a Past Outputs Multivariable Output Error State-Space (PO-MOESP) algorithm or Canonical Variate Analysis (CVA) to generate the real-time model based on the sensed data. The subspace identification methods (SIMs), such as past outputs multivariable output-error state space (PO-MOESP), numerical algorithms for subspace state-space system identification (N4SID), and Canonical Variate Analysis, generate a real-time model (e.g. a state-space model) based on the sensed data. Multivariable Output Error State Space (MOESP) and Numerical algorithms for Subspace State Space System Identification (N4SID) algorithms are two known subspace identification techniques. The numerical algorithm for Subspace and State-Space identification is typically faster, when implemented correctly, than prediction error methods, because the numerical algorithm for Subspace and State-Space identification are basically non-iterative, exploiting basic algorithms from numerical linear algebra, such as LQ-decomposition (transpose of the QR decomposition) and the singular value decomposition to generate the real-time model based on the sensed data. In an embodiment, the data processing arrangement is configured to compute an analysis of at least one of the numerical algorithm for Sub-Space State-Space System Identification (N4SID), the Multivariable Output Error State Space (MOESP) algorithm, the Past Outputs Multivariable Output Error State-Space (PO-MOESP) algorithm or the Canonical Variate Analysis (CVA) to generate the stored model or linear model based on the voltage and the current signals obtained from the electrical device. However, use of aforesaid known methods of performing data processing is not known in the context of the present disclosure.

According to yet another embodiment, the data processing arrangement is operable to:
(i) generate a linear model describing the electrical device;
(ii) use the linear model to create a model of predicted current of the electrical device from measured voltages obtained from the electrical device;
(iii) compare the model of predicted current with a measured current of the electrical device to create a residual current data;
(iv) perform Fast Fourier Transform (FFT) on the residual current data to create the temporally-changing Fourier spectrum;
(v) identify the at least one local maximum on the temporally-changing Fourier spectrum using a crawling technique to divide an entirety of the temporally-changing Fourier spectrum into local maxima joined to one another at local minima, wherein the crawling technique identifies the at least one local maximum on the temporally-changing Fourier spectrum by determining a value that increases towards the at least one local maximum or a value that decreases from the at least one local maximum;
(vi) identify the significant local maximum in terms of an absolute value or number of standard deviations from a mean value; and
(vii) label the significant local maximum with the phenomenon description in the user interface for presenting to the user.

In an embodiment, the electrical condition monitoring system identifies each point on the temporally-changing Fourier spectrum and travels right and left on the temporally-changing Fourier spectrum, for example as shown in a graphical form (with reference to an abscissa frequency axis) to a given user via the aforementioned user interface. The electrical condition monitoring system determines a value that increases towards the point or a value that decreases from the point. In an embodiment, if the values on each side of the point are lower, then the point is identified as a local maximum. In another embodiment, if the values on each side of the point is higher, then the point is referred as a local minimum. The electrical condition monitoring system may identify all the local maxima and local minima on the temporally-changing Fourier spectrum and divide the entire temporally-changing Fourier spectrum into local maxima, which abut one another at the local minima.

The present disclosure also provides a method for (of) using an electrical condition monitoring system that is connectable to an electrical device, and that is configured to monitor the electrical device when the electrical device is in operation, wherein the method includes:
(i) using a sensing arrangement of the electrical condition monitoring system for temporally sensing an electrical supply to and/or from the electrical device and generating corresponding sensed data by processing the sensed electrical supply to and/or from the electrical device, wherein the sensed data includes information associated with at least one of a supply of voltage or a supply of current to and/or from the electrical device;
(ii) using a data processor of a data processing arrangement of the electrical condition monitoring system, to process the sensed data to generate a corresponding temporally-changing Fourier spectrum including signal harmonic components for at least one of the current or the voltage that is supplied to and/or from the electrical device (optionally, or to a calculated residual current or residual voltage, wherein a calculated residual current is calculated by comparing a model of predicted current with a measured current of the electrical device to generate residual current data); and to process temporal changes in magnitudes and frequencies of the signal harmonic components to generate analysis data representative of operation of the electrical device; and
(iii) configuring a user interface for user entry of input for analyzing the analysis data and using the data processor to analyze the analysis data based on the input to obtain information indicative of an operating condition of the electrical device;
characterized in that the method includes:
(iv) operating the data processing arrangement to at least partially filter out the changes in magnitudes and frequencies of the signal harmonic components caused due to electrical distortion noise, for example switching noise, non-linearity noise (e.g. magnetic saturation noise), spark discharge noise, present in the temporally-changing Fourier spectrum;
(v) operating the data processing arrangement to identify at least one local maximum corresponding to a phenomenon on the temporally-changing Fourier spectrum by analyzing the temporally-changing Fourier spectrum that are plotted based on the sensed data;
(vi) operating the data processing arrangement to calculate locations on the temporally-changing Fourier spectrum where the same phenomenon appears to create a family of possible local maxima;
(vii) operating the data processing arrangement to identify a significant local maximum from the family of possible local maxima corresponding to the phenomenon and to generate the analysis data from a magnitude of the significant local maximum;
(viii) operating the data processing arrangement to generate a real-time model of the electrical device based on the analysis data; and
(ix) operating the data processing arrangement to access one or more stored models of operation of the electrical device, and to compare the real-time model with the one or more stored models to generate information indicative of an operating condition of the electrical device.

According to an embodiment, the method includes using the data processing arrangement to compute parameter differences between the real-time model and the one or more stored models, and to generate a predictive model describing the parameter difference to generate the information indicative of an operating condition of the electrical device.

According to another embodiment, the method includes using the data processing arrangement to generate from the predictive model one or more alerts relating to:
(a) energy utilization trends of the electrical device;
(b) Carbon Dioxide (equivalent) generation being caused by and/or saved by the electrical device; and
(c) maintenance, replacement or repair of the electrical device, for example a state of insulation employed in the electrical device.

According to yet another embodiment, the method includes configuring the user interface for user entry of user defined parameters for generating a range of multivariate cells in a database of the electrical condition monitoring system and using the data processing arrangement to update the sensed data of the electrical device in their respective multivariate cells, wherein the multivariate cells store the temporally-changing Fourier spectrum associated with the sensed data and the one or more stored models associated with the electrical device.

According to yet another embodiment, the method includes using the data processing arrangement to update pre-existing analysis data in their respective multivariate cells with the analysis data to generate an updated average and a standard deviation for the sensed data.

According to yet another embodiment, the method includes using the data processing arrangement to decimate data points in the sensed data based on calculated frequency to determine a number of relevant data points for generating the temporally-changing Fourier spectrum.

According to yet another embodiment, the electrical device includes at least one of: a synchronous 1-phase electrical motor, a synchronous multi-phase electrical motor, a synchronous 3-phase electrical motor, a switched reluctance motor, a switched stepper motor, a D.C. electrical motor, a compressor, a pump, a fan, a conveyor, an agitator, a blender, a blower, a mixer, a Permanent Magnet (PM) motor, a PM generator, a synchronous 1-phase electrical generator, a synchronous multi-phase electrical generator, a synchronous 3-phase electrical generator, a D.C. electrical generator, a power transformer, an air conditioner, a ventilator, an oven or a solar panel. However, the electrical device optionally includes static devices, for example ovens, solar panels, and similar.

According to yet another embodiment, the method includes configuring the user interface for user entry of machine parameters describing the electrical device, wherein the machine parameters include at least one of: generic nominal operating voltage, generic nominal operating current, generic nominal supply frequency, generic nominal rotational speed, number of vanes on an impeller of the electrical device, bearing type codes of the electrical device or belt drive dimensions of the electrical device.

According to yet another embodiment, the method includes configuring the user interface for user entry of machine parameters describing analysis type to be executed by the data processing arrangement, wherein the analysis type allows user-setting of temporal resolution and a sensing data sample length.

According to yet another embodiment, the method includes using the user interface for user setting of voltage and/or current readings from the electric device at a sample rate of at least 2 MegaHertz (2 MHz) to 10 MegaHertz (10 MHz). Optionally, sample rates employed are in excess of 10 MHz.

Optionally, sample rates of 100 KHz are employed, decimated into a selectable frequency range of 2.5 kHz to 25 kHz. However, it will be appreciated that the sample rate accommodated is up to 1 MHz. Yet more optionally, the sampling rate is in a range of 2.5 kHz to 125 MHz, for example selectable within this range.

According to yet another embodiment, the method includes using the user interface to allow user-selection for implementing D-Q phase and A-B phase transformation, computed in the data processing arrangement, of the sensed data, wherein the D-Q phase transformation transfers three-phase stator and rotor quantities into a single rotating reference frame to eliminate an effect of time-varying inductances, wherein the A-B phase transformation refers to a mathematical transformation that is implemented to simplify the analysis of three-phase stator and rotor.

According to yet another embodiment, the method includes configuring the data processing arrangement to create a linear model of one or more relationships between voltage and current signals obtained from the electrical device

According to yet another embodiment, the method includes configuring the data processing arrangement to compute an analysis of at least one of a numerical algorithm for Sub-Space State-Space System Identification (N4SID), a Multivariable Output Error State Space (MOESP) algorithm, a Past Outputs Multivariable Output Error State-Space (PO-MOESP) algorithm or Canonical Variate Analysis (CVA) to generate the real-time model based on the sensed data.

According to yet another embodiment, the method includes operating the data processing arrangement to:
(i) generate a linear model describing the electrical device;
(ii) use the linear model to create a model of predicted current of the electrical device from measured voltages obtained from the electrical device;
(iii) compare the model of predicted current with a measured current of the electrical device to create a residual current data;
(iv) perform Fast Fourier Transform (FFT) on the residual current data to create the temporally-changing Fourier spectrum;
(v) identify the at least one local maximum on the temporally-changing Fourier spectrum using a crawling technique to divide an entirety of the temporally-changing Fourier spectrum into local maxima joined to one another at local minima, wherein the crawling technique identifies the at least one local maximum on the temporally-changing Fourier spectrum by determining a value that increases towards the at least one local maximum or a value that decreases from the at least one local maximum;
(vi) identify the significant local maximum in terms of an absolute value or number of standard deviations from a mean value; and
(vii) label the significant local maximum with the phenomenon description in the user interface for presenting to the user

The advantages of the present method are thus identical to those disclosed above in connection with the present system and the embodiments listed above in connection with the present system apply *mutatis mutandis* to the present method.

The present disclosure also provides a computer program product comprising a non-transitory computer-readable storage medium having computer-readable instructions stored thereon, the computer-readable instructions being executable by a computerized device comprising processing hardware to execute the aforesaid method.

The advantages of the present computer program product are thus identical to those disclosed above in connection with the present system and the embodiments listed above in connection with the present system apply *mutatis mutandis* to the computer program product.

Embodiments of the present disclosure thus monitor the operating condition of the electrical device (e.g. a health of the electrical device) more accurately than the existing monitoring systems, over a period of time. Embodiments of the present disclosure may help to avoid performing unnecessary maintenance works on the electrical device; such avoidance is especially valuable when the electrical device is at a remote location that is costly and/or difficult to access, for example remote pumps, remote motor-actuated barriers, remote hydroelectric generators, remote wind turbines, remote tidal turbines, remote geothermal turbines, remote ocean wave turbines and so forth. Embodiments of the present disclosure thus manage processing of current and voltage measurements having distortion and infer the sensed data from measured voltage and current signals, despite the voltage and current signals are being distorted, for effectively monitoring the operating condition of the electrical device. Embodiments of the present disclosure may be easily connected with the electrical system and may not require any configuration changes in the electrical device to deploy it. Embodiments of the present disclosure help to save the maintenance cost of the electrical device to a larger extent by adopting a condition-based maintenance strategy for the maintenance of the electrical device.

### DETAILED DESCRIPTION OF THE DRAWINGS

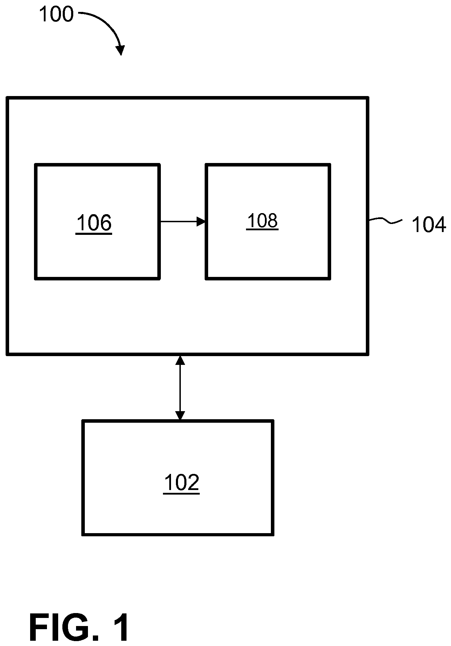

FIG. 1 is a schematic illustration of an electrical condition monitoring system in accordance with an embodiment of the present disclosure. The electrical condition monitoring system **100** includes an electrical device **102** and an electrical condition monitoring system **104.** The electrical condition monitoring system **104** includes a sensing arrangement **106** and a data processing arrangement **108.** These parts have functions as have been described above.

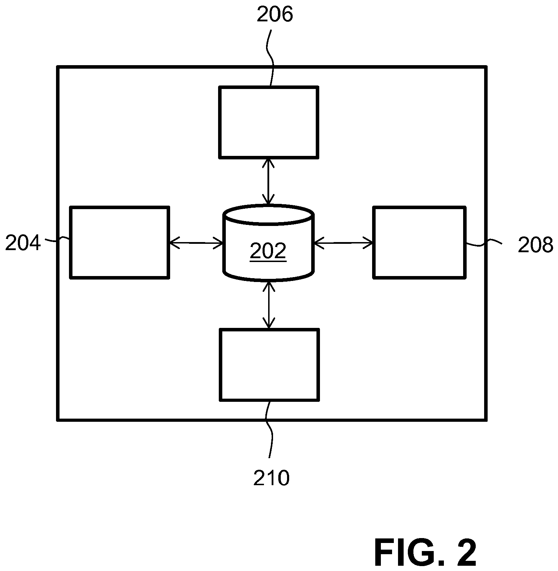

FIG. 2 is a functional block diagram of a data processing arrangement in accordance with an embodiment of the present disclosure. The functional block diagram of the data processing arrangement comprises a database **202,** a filtering module **204,** a spectrum analysis module **206,** a real-time model generation module **208** and a model comparison module **210.** The database **202** includes a range of multivariate cells, for example stored in a data memory. The multivariate cells store sensed data of an electrical device. The multivariate cells store a temporally-changing Fourier spectrum associated with the sensed data and one or more stored models associated with the electrical device. The filtering module **204** partially filters out changes in magnitudes and frequencies of signal harmonic components caused due to electrical distortions, for example switching noise, present in the temporally-changing Fourier spectrum. The spectrum analysis module **206** identifies at least one local maximum corresponding to a phenomenon on the temporally-changing Fourier spectrum by analyzing the temporally-changing Fourier spectrum that are plotted based on the sensed data. The spectrum analysis module **206** calculates locations on the temporally-changing Fourier spectrum where the same phenomenon appears to create a family of possible local maxima. The spectrum analysis module **206** identifies a significant local maximum from the family of possible local maxima corresponding to the phenomenon and to generate analysis data from a magnitude of the significant local maximum. The real-time model generation module **208** generates a real-time model of the electrical device based on the analysis data. The model comparison module **210** accesses one or more stored models of operation of the electrical device and compares the real-time model with the one or more stored models to generate information indicative of an operating condition of the electrical device.

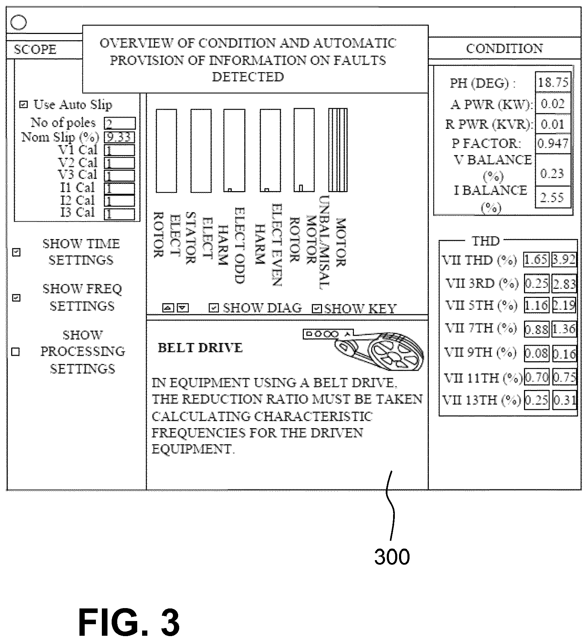

FIG. 3 is an exemplary view of a graphical user interface (GUI) **300** of an electrical condition monitoring system in accordance with an embodiment of the present disclosure. The graphical user interface **300** depicts bar graphs that shows an operating condition of an electrical device and information associated with faults detected in the electrical device (e.g. a belt drive). The bar graphs show operating conditions of different parts of the electrical device such as an electrical rotor, an electrical stator, an electrical odd harmonic, an electrical even harmonic, a motor rotor etc. Each bar graph may represent a fault on different parts of the electrical device.

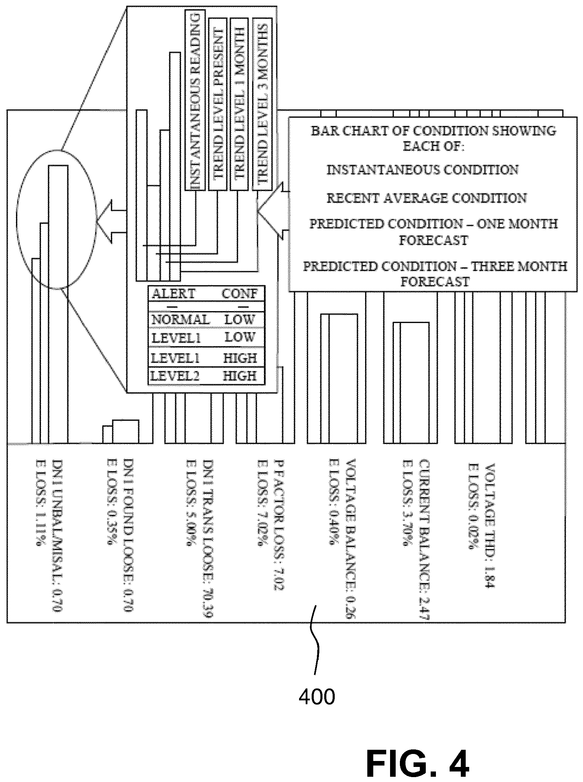

FIG. 4 is an exemplary view of a graphical user interface **400** of an electrical condition monitoring system that depicts operating conditions of an electrical device in accordance with an embodiment of the present disclosure. The graphical user interface **400** depicts bar graphs that show instantaneous operating condition of the electrical device based on current reading, recent average operating condition of the electrical device, predicted operating condition of the electrical device for one month and three-month forecast.

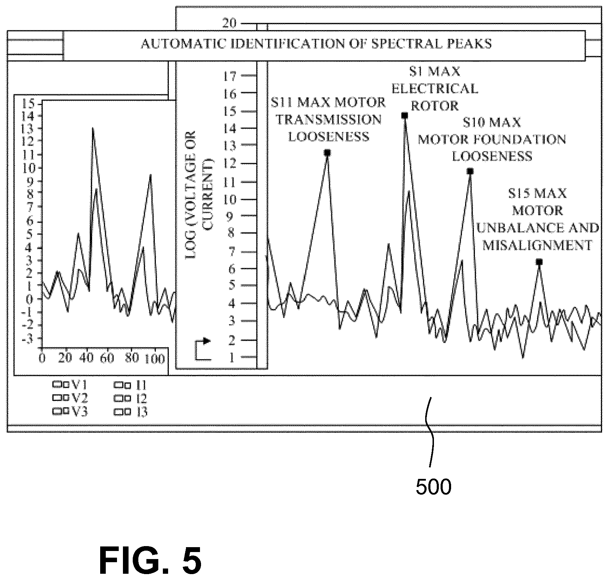

FIG. 5 is an exemplary view of a graphical user interface **500** of an electrical condition monitoring system that depicts an identification of peaks (namely, maxima) in a temporally-changing Fourier spectrum in accordance with an embodiment of the present disclosure. The graphical user interface **500** depicts identification of various peaks (e.g. local maximum) corresponding to different phenomenon on the temporally-changing Fourier spectrum that is generated based on sensed data of an electrical device. For example, a peak S1 depicts an operating condition of an electrical rotor associated with the electrical device, a peak S10 depicts motor foundation looseness in the electrical device, a peak S11 depicts motor transmission looseness in the electrical device and a peak S15 depicts driven unbalance and misalignment in the electrical device.

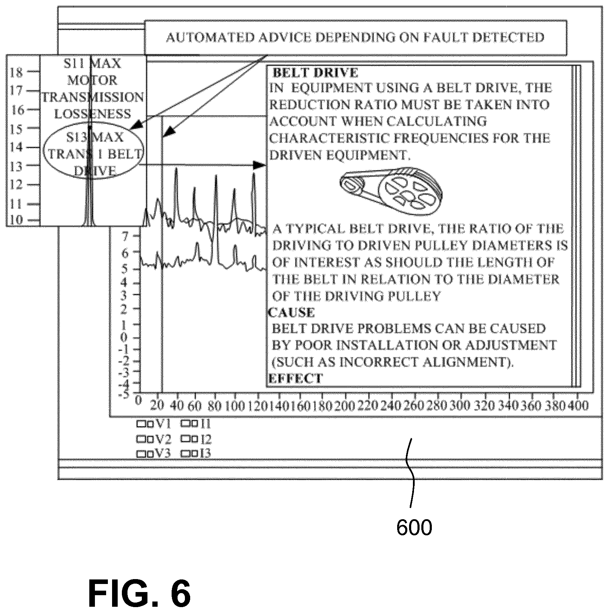

FIG. 6 is an exemplary view of a graphical user interface **600** of an electrical condition monitoring system that depicts suggestions to a fault detected in an electrical device (e.g. belt drive) in accordance with an embodiment of the present disclosure. The graphical user interface **600** shows a family of possible peaks (e.g. local maxima) corresponding to a phenomenon (e.g. fault / problem). The graphical user interface **600** provides a description, a cause and an effect of a fault detected in a belt drive. For example, the description provides information associated with faults / problems detected in the belt drive. The description indicates that the problem / fault detected in the belt drive is due to poor installation or an adjustment (e.g. incorrect alignment), excessive loads or incorrect tensioning in the belt drive.

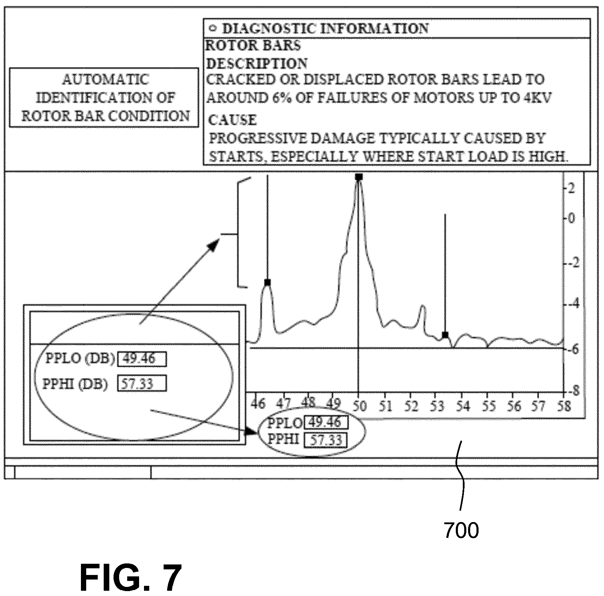

FIG. 7 is an exemplary view of a graphical user interface **700** of an electrical condition monitoring system that depicts automatic identification an operating condition of a rotor bar in accordance with an embodiment of the present disclosure. The graphical user interface **700** shows a peak (e.g. local maximum) that indicates an operating condition of the rotor bar along with a description pertaining thereto. The description indicates that the rotor bar is cracked or displaced which leads to around 6% of failures of motors, *mutatis mutandis* generators, up to 4 kiloVolt (4 kV) specification and around 13% of failures of the motor, *mutatis mutandis* generators, above 4 kiloVolt (4 kV) specification. The graphical user interface **700** also depicts that the crack or displacement of rotor bar may be caused by starts, specifically when a given start load is excessively high and caused by high load variations and time-related deterioration.

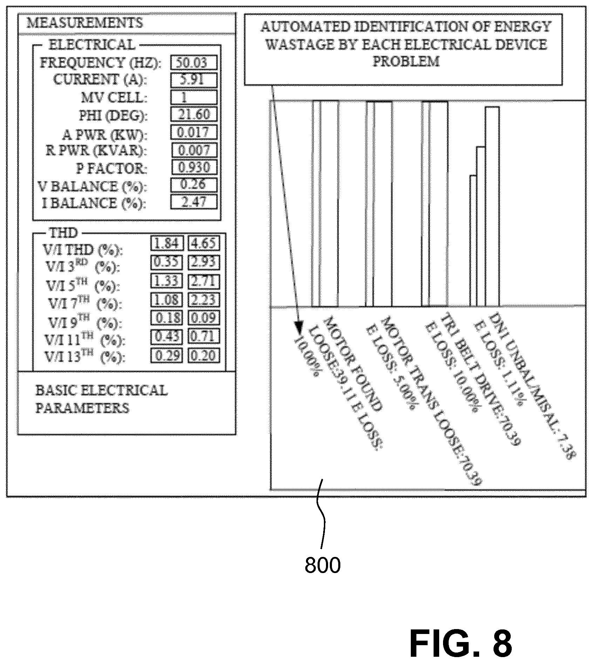

FIG. 8 is an exemplary view of a graphical user interface **800** of an electrical condition monitoring system that depicts automatic identification of energy wastage in an electrical device in accordance with an embodiment of the present disclosure. The graphical user interface **800** shows a family of peaks (e.g. local maxima) that indicate automatic identification of the energy wastages occurred due to a problem / fault in the electrical device.

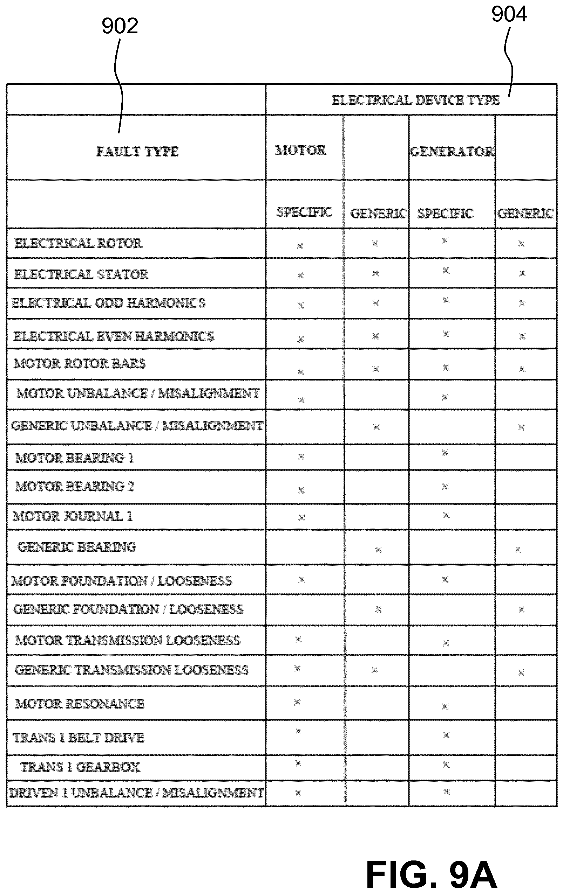

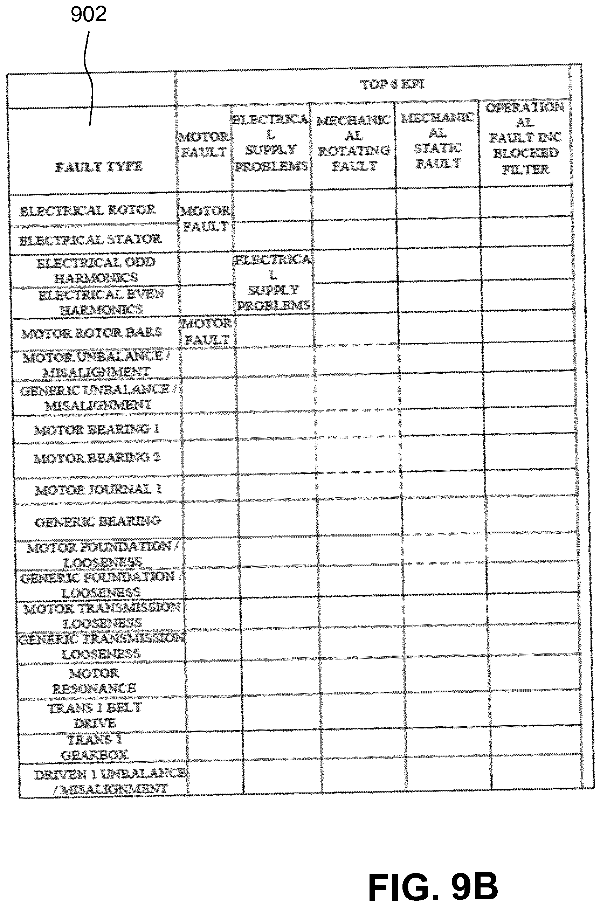

FIGS. 9A and 9B are exemplary tabular views that depict detection of faults in an electrical device using an electrical condition monitoring system in accordance with an embodiment of the present disclosure. The tabular views show a fault type field **902** and an electrical device type field **904.** The fault type field **902** includes a type of faults detected in different parts (e.g. an electrical rotor, an electrical stator, motor rotor bars, a motor bearing 1, a motor bearing 2, electrical generator bars, a generator bearing 1, a generator bearing 2, etc.) of the electrical device. The electrical device type field **904** includes a different type of electrical devices (e.g. a motor and a generator). The tabular views depict types (e.g. generic faults and specific faults) of faults detected in the different electrical devices. Generic faults are detected when there is no special information entered about the electrical device apart from its nominal voltage, nominal current and nominal rotational speed. Specific faults are detected when appropriate information (typically, rotating element bearing type code numbers, a ratio of transmissions and pulley diameters and separation distance for belt drives) is entered into the electrical condition monitoring system.

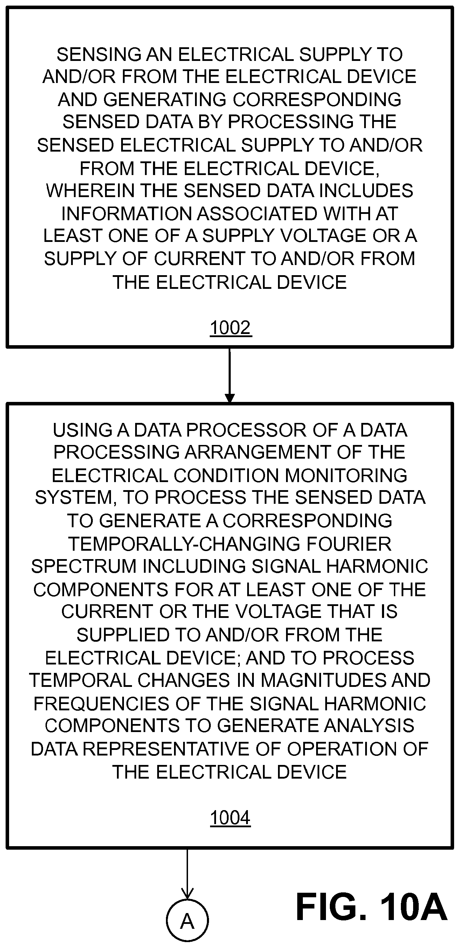

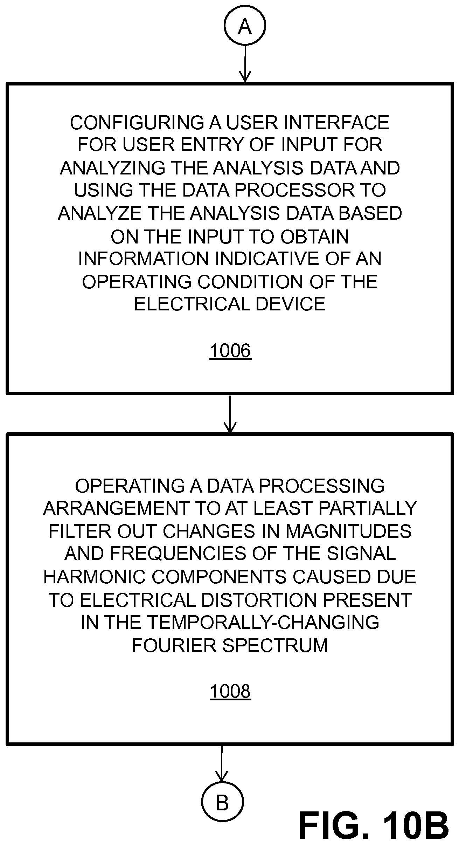

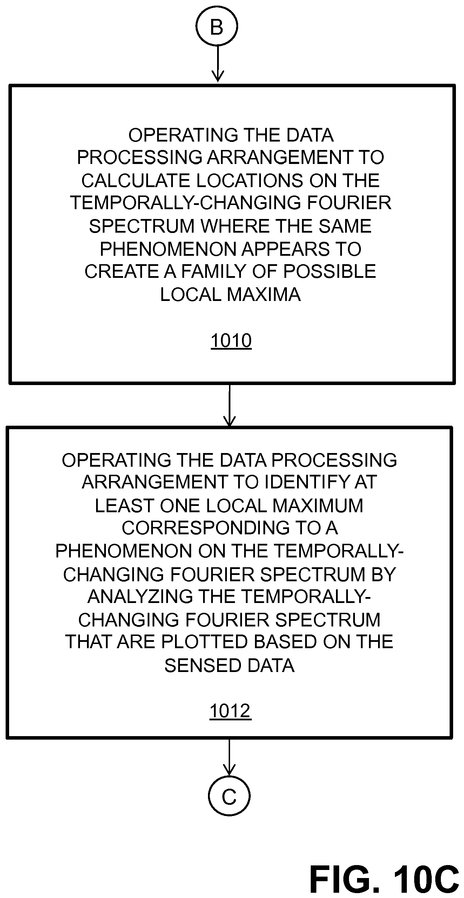

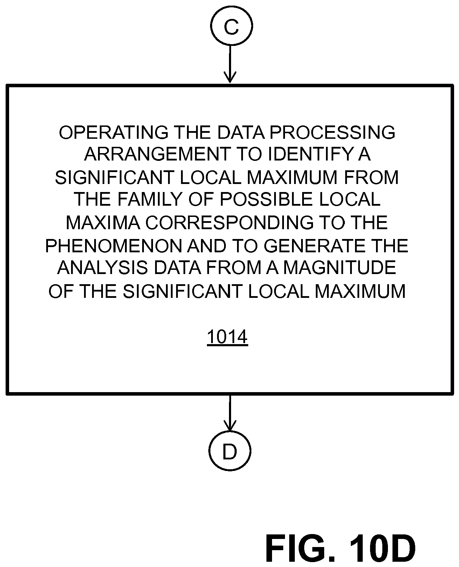

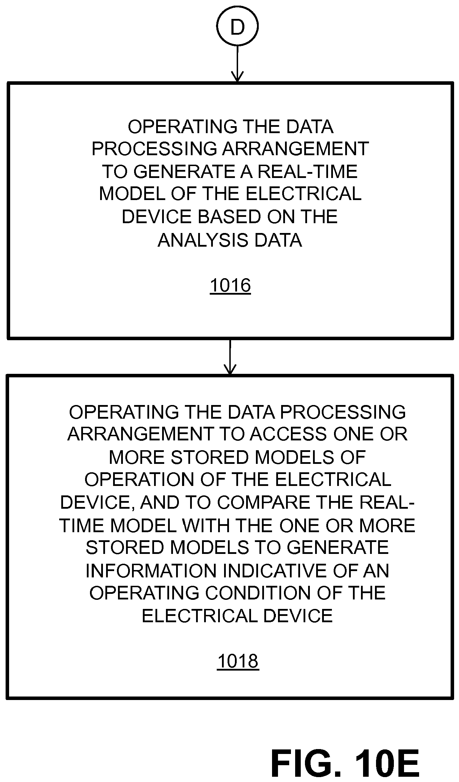

FIGS. 10A to 10E are flow diagrams illustrating steps of a method **1000** in accordance with an embodiment of the present disclosure. At a step **1002,** an electrical supply to, and/or an electrical supply from, an electrical device is temporally sensed using a sensing arrangement of the electrical condition monitoring system and corresponding sensed data is generated by processing the sensed electrical supply to and/or from the electrical device. The sensed data includes information associated with at least one of a supply of voltage or a supply of current to and/or from the electrical device. At a step **1004,** the sensed data is processed to generate a corresponding temporally-changing Fourier spectrum including signal harmonic components for at least one of the current or the voltage that is supplied to, and/or generated from, the electrical device and the temporal changes in magnitudes and frequencies of the signal harmonic components are processed to generate analysis data representative of operation of the electrical device using a data processor of a data processing arrangement of the electrical condition monitoring system. At a step **1006,** a user interface is configured for user entry of input for analyzing the analysis data, and the data processor is configured to (namely, functions when in operation to) analyze the analysis data to obtain information indicative of an operating condition of the electrical device. At a step **1008,** the data processing arrangement is operable at least partially to filter out the changes in magnitudes and frequencies of the signal harmonic components caused due to electrical distortions, for example switching noise, present in the temporally-changing Fourier spectrum. At a step **1010,** the data processing arrangement is operable to identify at least one local maximum corresponding to a phenomenon on the temporally-changing Fourier spectrum by analysing the temporally-changing Fourier spectrum that are plotted based on the sensed data. At a step **1012,** the data processing arrangement is operable to calculate locations on the temporally-changing Fourier spectrum where the same phenomenon appears to create a family of possible local maxima; identification of such clustering of a family of a plurality of local maxima is beneficial in providing more reliable predictions and hence avoiding false alarms (namely, *"false positives"*) that can be costly and/or time consuming to address. At a step **1014,** the data processing arrangement is operable to identify a significant local maximum from the family of possible local maxima corresponding to the phenomenon and to generate the analysis data from a magnitude of the significant local maximum. At a step **1016,** the data processing arrangement is operable to generate a real-time model of the electrical device based on the analysis data. At a step **1018,** the data processing arrangement is operable to access one or more stored models of operation of the electrical device, and to compare the real-time model with the one or more stored models to generate information indicative of an operating condition of the electrical device.

Embodiments of the present disclosure concern a type of technology that is capable of reducing Carbon Dioxide (CO₂) emissions, as a result of improving operation of electrical devices, for example electrical machines, at higher efficiency and avoiding unnecessary maintenance.

Although sensing and monitoring of a single electrical device is described in the foregoing, it will be appreciated that the electrical condition monitoring system **100** is capable of being arranged, namely configured, so that the sensing arrangement **106** senses currents and/or voltages of connection points that are coupled to a plurality of electrical devices; for example, the sensing arrangement (for example, implemented as voltage probes and/or clamp-on current sensors) **106** is coupled at a main electrical junction box that feeds, or receives power from, an array of electrical devices. In such an embodiment, the filtering module **204,** the spectrum analysis module **206,** the real-time model generation module **208** and the model comparison module **210** are arranged to employ one or more models corresponding to an aggregate of a plurality of electrical devices. However, the electrical devices are potentially operating in mutually different states (for example, some motors or generators being stationary whereas other of the motors or generators being operable at mutually different power magnitudes or rotation rates) that makes the system **100** more complex in its operation. However, such a manner of operation is potentially cost-effective, because installing the sensor arrangement **106** may be a costly personnel-intensive (namely, labor-intensive) activity, for example where remote telemetry is also required.

In other words, the system **100** is able to connect to multiple motors, multiple generators, or a combination of one or more motors and one or more generators, and diagnose faults or other phenomena occurring in any one of the motors and/or generators. The sensing arrangement **106,** for example, is conveniently coupled at a switchboard associated with the multiple motors, multiple generators, or combination thereof.

Employing the system **100** to monitor and diagnose concurrently multiple electrical devices is more complex, because signals generated from the sensor arrangement **106** in respect of the multiple electrical devices is effectively aggregated, namely mutually merged into a single signal. The system **100** is able to identify individual parameters in a meaningful way from such an aggregate signal. Where the different motors, alternatively different generators, or both, are driving different types of equipment, the profile of each type of equipment is different, and at least some of the fault frequencies pertaining to the equipment will be different. By building up a profile of each motor in turn, *mutatis mutandis* each generator in turn, the system **100** is able to build an expected profile in total of all the motors running at that time, *mutatis mutandis* generators running at that time, and then compare it with the actual overall profile (namely spectrum). Where the motors, *mutatis mutandis* the generators, are driving, or being driven by, identical types of equipment, the fault frequencies will be identical for each item of equipment. The system **100** is able to identify a nature of the fault, but not which motor, *mutatis mutandis* generator, is responsible for the fault. Optionally, narrowing down a given motor, *mutatis mutandis* a given generator, with the fault is achieved in the system **100** by correlating a presence or absence at a given time of the fault signal with which motors, *mutatis mutandis* which generators, are or are not running at that given time.

The system **100** is capable of being operated to determine and record a set of baselines corresponding to a range of combinations of operational parameters that pertain to one or more motors, and/or one or more generators. Such operation parameters concern, for example, a relationship between load and rotation speed of a given electrical device, for example manifest as a relationship between current and rotational frequency of the electrical device; in the system **100,** subsequent monitoring and diagnostics are implemented by comparing subsequently monitored measurements or derived data against such baselines.

As aforementioned, the real-time model generation module **208** generates a real-time model of the electrical device based on the analysis data. This real-time model corresponding to baseline information is conveniently stored in multivariate cells within computing hardware, that are filled by actual measurements, in other words sensor data, during a baselining process when initially characterizing a given electrical device, for example an electrical motor or an electrical generator. However, in a case where not every relevant combination of operational parameters has been encountered during such a baselining process, data appropriate to unencountered combinations of operational parameters are optionally created by a suitable mathematical method; this mathematical method is optionally implemented as follows, for example:
(i) there is employed a process of interpolation or extrapolation from the baseline data in nearby (for example, neighboring) multivariate cells, to create a matrix of extrapolated multivariate cells across a range of operational parameters of interest. Optionally, this matrix of extrapolated multivariate cells is updated, using an updating process, with actual data subsequently collected after the initial baselining process has been completed; or
(ii) there is employed a process of creating a mathematical relationship between the monitored measurements or derived data and the operational parameters in a form (conceptually) of an equivalent 3-dimensional or multidimensional *"surface".* This relationship is then used to calculate the values of monitored measurements and/or derived data that would be expected for any combination of values of aforesaid operational parameters.

It will be appreciated that by interpretation of *"model parameters",* these may be parameters of the mathematical models used in the system **100** or may be parameters that describe physical quantities of a given motor or generator, such as rotor resistance, rotor reactance, stator resistance, stator reactance.

It will further be appreciated that the electrical condition monitoring system **100,** namely operating as a form of diagnostic system, identifies distortions in a sensed current signal that has a current waveform that have not been caused by distortions of a corresponding voltage signal that has a voltage waveform, to create a residual current signal, which is then used for executing further analysis. Temporal changes in a given electrical device, for example a load applied to a motor or output from a generator, causes a change in the overall current drawn or supplied by the electrical device, without causing significant change in the voltage signal, so such load or output changes result in apparent changes in the residual current. These apparent changes, in earlier known diagnostic system, potentially lead to spurious identification of faults. Embodiments of the present disclosure by capturing a range of *"typical"* readings and their associated spectra and model parameters, and storing associated data representative of the spectra and model parameters in individual cells of a matrix defining a relationship between load and rotation speed (i.e. rotation frequency), or output and rotation speed (i.e. rotation frequency). Optionally, embodiments of the present disclosure capture multiple sets of data for each combination of load and speed for a motor, *mutatis mutandis* output and speed for a generator, and average them or aggregate them as a part of a baselining process employed within the electrical condition monitoring system **100.** The diagnosis of problems is then based in the system **100** on a comparison of a reading at any particular time against the baseline established for that combination of load and speed for the given motor, *mutatis mutandis* output and speed for the given generator. The greater the number of cells employed in the aforesaid matrix, the closer the comparison between the monitoring and baseline readings, and therefore the more valid the diagnosis provided by the system **100** when in operation. However, the larger the number of cells in the matrix, the lower the likelihood of all cells being encountered during the baselining process, and hence the need to fill in these empty cells in some way, for example by way of using extrapolation or interpolation as aforementioned.

As aforementioned, the mathematical methods employed within the system **100** for identifying distortions on a current waveform that have not been caused by distortions on a corresponding voltage waveform involves creating mathematical models of the relationship between voltage and current measurements. Moreover, as aforementioned, these models utilize a plurality of model parameters, whose values potentially temporally change each time a measurement is taken using the system **100.** By relating such model parameters to a physical model of an electric motor, *mutatis mutandis* an electrical generator, the values of the physical parameters, such as rotor resistance, stator resistance and so forth, may be assessed, in particular by identifying changes in the model parameters that may be related to underlying physical changes.

Detection of such changes, for example, allows detection to be made of early stages of electrical insulation breakdown, for example rotor and/or stator electrical winding breakdown; such an early detection is achieved by measuring the capacitance and resistance of the insulation at a range of frequencies, by analyzing a relationship between voltage and current at a range of different frequency components by using harmonics already present in the voltage and current signals, for example isolated by performing aforesaid Fourier analysis of measured current and voltage signal captured by the system **100.** In contradistinction, traditional *"simple"* methods of assessing integrity of insulation involves measuring a resistance from a conductor abutting the insulation to Earth. This resistance is normally very high, namely in an order of MegaOhms. If the insulation has already failed, the insulation will have a resistance that will be very much lower, possibly in an order of a few Ohms only; often, the insulation is a polymer plastics material that can be decomposed to Carbon that is an electrical conductor. Such a traditional technique is not good at identifying gradual deterioration, and so is not very helpful at giving predictive warnings of insulation breakdown; moreover, these traditional techniques are generally only possible when the given motor, *mutatis mutandis* the given generator, is disconnected from the electricity supply powering the motor, *mutatis mutandis* is disconnected from the electricity network to which the given generator is providing power. Thus, it will be appreciated that the system **100** is capable of providing real-time continuous monitoring of insulation integrity of electrical motors, *mutatis mutandis* electrical generators.

A more sensitive technique employable in the system **100** for detecting earlier a deterioration of a given insulation, and hence giving an earlier warning of impending problems, relies on a characteristic that a given insulation gradually changes chemically over a period of time, for example due to chemical oxidation processing and/or metal migration processes. These chemical changes result in a change in its electrical behavior of the given insulation; principally, there is a reduction in a capacitance exhibited by the given insulation and a change, for example an increase or decrease in its resistive behavior, which results in a change in the phase angle (or "tan delta") between the voltage applied to the insulation and a (very small, for example nano-Amperes or micro-Amperes) leakage current flowing through it, when in use. The system **100** is configurable to operate to measure the phase angle (or "tan delta").

Computations implemented in the system **100** are based a behavior of a perfect insulator being conceptually thought of as an array of little capacitive elements connected in matrix manner in series and in parallel. On account of there being all capacitive elements, there is no DC current if a DC voltage is applied to the perfect insulator; however, when an alternating AC voltage is applied to the perfect insulator, there will be a capacitive current flowing that will increase as an alternating frequency increases (basis for computation: I = C.dv/dt, wherein I is a current, C is capacitance, and dv/dt is a temporal rate of voltage change applied to the capacitance C). As a pure capacitive current, this will flow at an orthogonal angle of 90 degrees (90°) to the applied voltage signal, with current leading voltage (engineering hint for understanding: "*CIVIL*" - in a capacitor, C, I before V; in an inductor, L, V before I; wherein V is an alternating sinusoidal voltage and I is an alternating sinusoidal current flowing). Over a period of time, when the perfect insulation is in use, the chemical change in the perfect insulation results in some of these little capacitive elements changing in nature to small resistive elements. While only a few of the capacitive elements have changed to being resistive elements, there is still no path for DC through to Earth through the aged perfect insulation, but the AC current will now have a different phase angle, as some of the AC current is now flowing through the resistive elements. By taking a plurality of readings at different frequencies, the values of the capacitive elements and resistive elements and phase angle can be calculated. Suh a technique for assessing early stage insulation problems is already used by specialist bench testers, for testing motors in a workshop, or when still *in situ* but *de-energized* (namely, disconnected from an electrical supply). The specialist bench testers connect across between conductors of the motor and Earth. Conventionally, a series of test signals is applied at a range of frequencies from which the "health" (namely, a degree of ageing) of the insulation can be assessed. In contradistinction to such conventional approaches, the system **100** is capable of assessing the health (namely, *"ageing"*) of the insulation during normal operation by utilizing measured harmonic components in an alternating voltage applied to the insulation, to assess the capacitive elements and resistive elements of the insulation, namely determinable from the aforesaid *"tan delta"* angle between current and voltage signals associated with the insulation.

Optionally, the system **100** measure transients when a given motor or generator coupled to the system **100** is started up into operation, for example rotationally accelerated from standstill to a rotating operational state. The aforesaid model used to describe the given motor or given generator (namely, as provided by the real-time model generation module **208** and utilized by the model comparison module **210** of the system **100)** beneficially includes parameters in the baseline that describe transient start-up, optionally shut-down, characteristics of the given motor or given generator. Such a manner of operation of the system **100** enables potential faults in switchgear to be identified that deliver or receive power to or from the given motor or generator, respectively.

The aforementioned multivariate cells are not limited to merely current and voltage measurements, whether obtained directly from measurements or generated by interpolation or extrapolation of data from neighboring multivariate cells, but optionally are additionally based on at least one of: temperature measurements, humidity measurements, vibration measurements. For example, temperature measurements allow coefficients of resistivity of winding elements to be taken into account, and humidity measurements enable insulation to be modelled more accurately (because polarized water molecules are able to modulate conduction characteristics of aged and compromised insulation materials).

## Claims

1. An electrical condition monitoring system (100) configured to monitor an electrical device (102) when the electrical device (102) is in operation, wherein the electrical condition monitoring system (100) comprises:
the electrical device (102);
a sensing arrangement (106);
a data processing arrangement (108); and
a user interface (300);
wherein:
(i) the sensing arrangement (106) is configured to temporally sense an electrical supply to and/or from the electrical device (102) and to generate corresponding sensed data by processing the sensed electrical supply to and/or from the electrical device (102), wherein the sensed data includes information associated with at least one of a supply of voltage or a supply of current to and/or from the electrical device (102);
(ii) the data processing arrangement (108) comprises a data processor that is configured to process the sensed data to generate a corresponding temporally-changing Fourier spectrum including signal harmonic components for at least one of the current or the voltage that is supplied to and/or from the electrical device (102) and to process temporal changes in magnitudes and frequencies of the signal harmonic components to generate analysis data representative of operation of the electrical device (102); and
(iii) the user interface (300) is configured for user entry of input for analyzing the analysis data and the data processor is configured to analyze the analysis data based on the input to obtain information indicative of an operating condition of the electrical device (102); **characterized in that** the data processing arrangement (108) is configured to:
at least partially filter out the changes in magnitudes and frequencies of the signal harmonic components caused due to electrical distortion present in the temporally-changing Fourier spectrum;
identify at least one local maximum corresponding to a phenomenon on the temporally-changing Fourier spectrum by analyzing the temporally-changing Fourier spectrum that are plotted based on the sensed data;
calculate locations on the temporally-changing Fourier spectrum where the same phenomenon appears to create a family of possible local maxima;
identify a significant local maximum from the family of possible local maxima corresponding to the phenomenon and to generate the analysis data from a magnitude of the significant local maximum;
generate a real-time model of the electrical device (102) based on the analysis data; and
access one or more stored models of operation of the electrical device (102), and to compare the real-time model with the one or more stored models to generate information indicative of an operating condition of the electrical device (102).

2. The electrical condition monitoring system (100) of claim 1, wherein, in (ii), the data processor is configured to use the at least one of the current or the voltage that is supplied to and/or from the electrical device (102) to calculate a residual current or a residual voltage, wherein the calculated residual voltage or residual current is calculated by comparing a model of predicted current with a measured current of the electrical device (102) to generate residual current data or residual voltage data.

3. The electrical condition monitoring system (100) of claim 1 or 2, wherein the data processing arrangement (108) is configured to compute parameter differences between the real-time model and the one or more stored models, and to generate a predictive model describing the parameter differences to generate the information indicative of an operating condition of the electrical device (102).

4. The electrical condition monitoring system (100) of claim 3, wherein the data processing arrangement (108) is configured to generate one or more alerts relating to:
(a) energy utilization and/or generation trends of the electrical device (102);
(b) Carbon Dioxide (equivalent) generation being caused and/or saved by the electrical device (102);
(c) maintenance, replacement or repair of the electrical device (102); and
(d) a state of insulation of the electrical device (102).

5. The electrical condition monitoring system (100) of any one of claims 1 to 4, wherein the user interface (300) is configured for user entry of user defined parameters for generating a range of multivariate cells in a database (202) of the electrical condition monitoring system (100) and the data processing arrangement (108) is configured to update the sensed data of the electrical device (102) in their respective multivariate cells, wherein the multivariate cells store the temporally-changing Fourier spectrum associated with the sensed data and the one or more stored models associated with the electrical device (102).

6. The electrical condition monitoring system (100) of claim 5, wherein the data processing arrangement (108) is configured to update pre-existing analysis data in their respective multivariate cells with the analysis data to generate an updated average and a standard deviation for the sensed data.

7. The electrical condition monitoring system (100) of claim 5, wherein the data processing arrangement (108) is configured to compute by extrapolation and/or interpolation data for unpopulated multivariate cells from neighboring multivariate cells that are based on at least one of: voltage measurements, current measurements, frequency measurements.

8. The electrical condition monitoring system (100) of any one of claims. 1 to 7, wherein the data processing arrangement (108) is configured to decimate data points in the sensed data based on calculated frequency to determine a number of relevant data points for generating the temporally-changing Fourier spectrum.

9. The electrical condition monitoring system (100) of any one of claims 1 to 8, wherein the electrical device (102) includes at least one of: a synchronous 1-phase electrical motor, a synchronous multi-phase electrical motor, a synchronous 3-phase electrical motor, a switched reluctance motor, a switched stepper motor, a D.C. electrical motor, a compressor, a pump, a fan, a conveyor, an agitator, a blender, a blower, a mixer, a Permanent Magnet (PM) motor, a PM generator, a power transformer, an air conditioner, a ventilator, an oven, a solar panel, a synchronous 1-phase electrical generator, a synchronous multi-phase electrical generator, a synchronous 3-phase electrical generator, a D.C. electrical generator, a Permanent Magnet (PM) generator.

10. The electrical condition monitoring system (100) of any one of claims 1 to 9, wherein the user interface (300) is configured for user entry of machine parameters describing the electrical device (102), wherein the machine parameters include at least one of: generic nominal operating voltage, generic nominal operating current, generic nominal supply frequency, generic nominal rotational speed, number of vanes on an impeller of the electrical device, bearing type codes of the electrical device or belt drive dimensions of the electrical device.

11. The electrical condition monitoring system (100) of any one of claims 1 to 9, wherein the user interface (300) is configured for user entry of machine parameters describing analysis type to be executed by the data processing arrangement (108), wherein the analysis type allows user-setting of temporal resolution and a sensing data sample length.

12. The electrical condition monitoring system (100) of claim 10, wherein the user interface (300) is configured to allow user setting of voltage and/or current readings from the electric device (102) at a sample rate of up to 10 Mega Hertz.

13. The electrical condition monitoring system (100) of any one of the preceding claims, wherein the user interface is configured to allow user-selection for implementing D-Q phase and A-B phase transformation, computed in the data processing arrangement, of the sensed data, wherein the D-Q phase transformation transfers three-phase stator and rotor quantities into a single rotating reference frame to eliminate an effect of time-varying inductances, wherein the A-B phase transformation refers to a mathematical transformation that is implemented to simplify an analysis of a three-phase stator and rotor.

14. The electrical condition monitoring system (100) of any one of the preceding claims, wherein the data processing arrangement (108) is configured to create a linear model of one or more relationships between voltage and current signals obtained from the electrical device (102).

15. The electrical condition monitoring system (100) of any one of the preceding claims, wherein the data processing arrangement (108) is configured to compute an analysis of at least one of a numerical algorithm for Sub-Space State-Space System Identification (N4SID), a Multivariable Output Error State Space (MOESP) algorithm, a Past Outputs Multivariable Output Error State-Space (PO-MOESP) algorithm or Canonical Variate Analysis (CVA) to generate the real-time model based on the sensed data.

16. The electrical condition monitoring system (100) of any one of the preceding claims, wherein the data processing arrangement (108) is configured to:
(i) generate a linear model describing the electrical device (102);
(ii) use the linear model to create a model of predicted current of the electrical device (102) from measured voltages obtained from the electrical device (102);
(iii) compare the model of predicted current with a measured current of the electrical device (102) to create a residual current data;
(iv) perform Fast Fourier Transform (FFT) on the residual current data to create the temporally-changing Fourier spectrum;
(v) identify the at least one local maximum on the temporally-changing Fourier spectrum using a crawling technique to divide an entirety of the temporally-changing Fourier spectrum into local maxima joined to one another at local minima, wherein the crawling technique identifies the at least one local maximum on the temporally-changing Fourier spectrum by determining a value that increases towards the at least one local maximum or a value that decreases from the at least one local maximum;
(vi) identify the significant local maximum in terms of an absolute value or number of standard deviations from a mean value; and
(vii) label the significant local maximum with the phenomenon description in the user interface for presenting to the user.

17. A method of using the electrical condition monitoring system (100) according to any of claims 1 to 16, wherein the method comprises:
(i) using the sensing arrangement (106) of the electrical condition monitoring system (100) to temporally sense an electrical supply to and/or from the electrical device (102) and to generate corresponding sensed data by processing the sensed electrical supply to and/or from the electrical device (102), wherein the sensed data includes information associated with at least one of a supply of voltage or a supply of current to and/or from the electrical device (102);
(ii) using the data processor of the data processing arrangement (108) of the electrical condition monitoring system (100), to process the sensed data to generate a corresponding temporally-changing Fourier spectrum including signal harmonic components for at least one of the current or the voltage that is supplied to and/or from the electrical device (102) and to process temporal changes in magnitudes and frequencies of the signal harmonic components to generate analysis data representative of operation of the electrical device (102); and
(iii) configuring the user interface (300) for user entry of input for analyzing the analysis data and using the data processor to analyze the analysis data based on the input to obtain information indicative of an operating condition of the electrical device (102);
**characterized in that** the method further comprises:
(iv) operating the data processing arrangement (108) to at least partially filter out the changes in magnitudes and frequencies of the signal harmonic components caused due to electrical distortion present in the temporally-changing Fourier spectrum;
(v) operating the data processing arrangement (108) to identify at least one local maximum corresponding to a phenomenon on the temporally-changing Fourier spectrum by analyzing the temporally-changing Fourier spectrum that are plotted based on the sensed data;
(vi) operating the data processing arrangement (108) to calculate locations on the temporally-changing Fourier spectrum where the same phenomenon appears to create a family of possible local maxima;
(vii) operating the data processing arrangement (108) to identify a significant local maximum from the family of possible local maxima corresponding to the phenomenon and to generate the analysis data from a magnitude of the significant local maximum;
(viii) operating the data processing arrangement (108) to generate a real-time model of the electrical device (102) based on the analysis data; and
(ix) operating the data processing arrangement (108) to access one or more stored models of operation of the electrical device (102), and to compare the real-time model with the one or more stored models to generate information indicative of an operating condition of the electrical device (102).

18. A computer program product comprising a non-transitory computer-readable storage medium having computer-readable instructions stored thereon to cause the system of claim 1 to execute all the steps of the method of claim 17.

## Patentansprüche

1. System zur Überwachung des elektrischen Zustands (100), das konfiguriert ist zum Überwachen einer elektrischen Vorrichtung (102), wenn die elektrische Vorrichtung (102) in Betrieb ist, wobei das System zur Überwachung des elektrischen Zustands (100) Folgendes umfasst:
die elektrische Vorrichtung (102);
eine Sensoranordnung (106);
eine Datenverarbeitungsanordnung (108); und
eine Benutzeroberfläche (300);
wobei
(i) die Sensoranordnung (106) konfiguriert ist zum zeitlichen Erfassen einer elektrischen Versorgung zu und/oder von der elektrischen Vorrichtung (102) und zum Erzeugen von entsprechenden erfassten Daten durch Verarbeiten der erfassten elektrischen Versorgung zu und/oder von der elektrischen Vorrichtung (102), wobei die erfassten Daten Informationen einschließen, die mindestens einer von einer Spannungsversorgung oder einer Stromversorgung zu und/oder von der elektrischen Vorrichtung (102) zugeordnet sind;
(ii) die Datenverarbeitungsanordnung (108) einen Datenprozessor umfasst, der dazu konfiguriert ist, die abgetasteten Daten zu verarbeiten, um ein entsprechendes sich zeitlich änderndes Fourier-Spektrum zu erzeugen, das Signaloberwellenkomponenten für mindestens eines von dem Strom oder der Spannung einschließt, die zu und/oder von der elektrischen Vorrichtung (102) geliefert werden, und um zeitliche Änderungen bei den Größen und Frequenzen der Signaloberwellenkomponenten zu verarbeiten, um Analysedaten zu erzeugen, die für den Betrieb der elektrischen Vorrichtung (102) repräsentativ sind; und
(iii) die Benutzeroberfläche (300) für eine Benutzereingabe von Eingabewerten zum Analysieren der Analysedaten konfiguriert ist und der Datenprozessor konfiguriert ist, um die Analysedaten basierend auf den Eingabewerten zu analysieren, um Informationen zu erhalten, die einen Betriebszustand der elektrischen Vorrichtung (102) angeben;
**dadurch gekennzeichnet, dass** die Datenverarbeitungsanordnung (108) konfiguriert ist zum:
mindestens teilweisen Herausfiltern der Änderungen bei den Größen und Frequenzen der Signaloberwellenkomponenten, die durch elektrische Verzerrungen verursacht werden, die in dem sich zeitlich ändernden Fourier-Spektrum vorhanden sind;
Identifizieren mindestens eines lokalen Maximums, das einem Phänomen auf dem sich zeitlich ändernden Fourier-Spektrum entspricht, durch Analysieren des sich zeitlich ändernden Fourier-Spektrums, das basierend auf den erfassten Daten aufgetragen wird;
Berechnen von Positionen auf dem sich zeitlich ändernden Fourier-Spektrum, an denen das gleiche Phänomen auftritt, um eine Familie möglicher lokaler Maxima zu erstellen;
Identifizieren eines signifikanten lokalen Maximums aus der Familie der möglichen lokalen Maxima, die dem Phänomen entsprechen, und Erzeugen der Analysedaten aus der Größenordnung des signifikanten lokalen Maximums;
Erzeugen eines Echtzeitmodells der elektrischen Vorrichtung (102) basierend auf den Analysedaten; und
Zugreifen auf ein oder mehrere gespeicherte Modelle des Betriebs der elektrischen Vorrichtung (102) und Vergleichen des Echtzeitmodells mit dem einen oder den mehreren gespeicherten Modellen, um Informationen zu erzeugen, die auf einen Betriebszustand der elektrischen Vorrichtung (102) hinweisen.

2. System zur Überwachung des elektrischen Zustands (100) nach Anspruch 1, wobei,
in (ii) der Prozessor konfiguriert ist, um mindestens eines von dem Strom oder der Spannung, der/die der elektrischen Vorrichtung (102) zu- oder von ihr abgeführt wird, zu verwenden, um einen Reststrom oder eine Restspannung zu berechnen, wobei die berechnete Restspannung oder der berechnete Reststrom durch Vergleichen eines Modells des vorhergesagten Stroms mit einem gemessenen Strom der elektrischen Vorrichtung (102) berechnet wird, um Reststromdaten oder Restspannungsdaten zu erzeugen.

3. System zur Überwachung des elektrischen Zustands (100) nach Anspruch 1 oder 2,
wobei die Datenverarbeitungsanordnung (108) konfiguriert ist, um Parameterdifferenzen zwischen dem Echtzeitmodell und dem einen oder den mehreren gespeicherten Modellen zu berechnen und ein Vorhersagemodell zu erzeugen, das die Parameterdifferenzen beschreibt, um die Informationen zu erzeugen, die auf einen Betriebszustand der elektrischen Vorrichtung (102) hinweisen.

4. System zur Überwachung des elektrischen Zustands (100) nach Anspruch 3, wobei,
die Datenverarbeitungsanordnung (108) konfiguriert ist, um eine oder mehrere Warnungen zu erzeugen in Bezug auf:
(a) Trends bei der Energienutzung und/oder -erzeugung der elektrischen Vorrichtung (102);
(b) Kohlendioxid-(Äquivalent)-Erzeugung, die durch die elektrische Vorrichtung (102) verursacht und/oder eingespart wird;
(c) Wartung, Austausch oder Reparatur der elektrischen Vorrichtung (102); und
(d) einen Isolationszustand der elektrischen Vorrichtung (102).

5. System zur Überwachung des elektrischen Zustands (100) nach einem der Ansprüche 1 bis 4, wobei die Benutzeroberfläche (300) zur Benutzereingabe von benutzerdefinierten Parametern zum Erzeugen eines Bereichs von multivariaten Zellen in einer Datenbank (202) des Systems zur Überwachung des elektrischen Zustands (100) konfiguriert ist und die Datenverarbeitungsanordnung (108) konfiguriert ist, um die erfassten Daten der elektrischen Vorrichtung (102) in ihren jeweiligen multivariaten Zellen zu aktualisieren, wobei in den multivariaten Zellen das sich zeitlich ändernde Fourier-Spektrum, das den erfassten Daten zugeordnet ist, und das eine oder die mehreren gespeicherten Modelle, die der elektrischen Vorrichtung (102) zugeordnet sind, gespeichert sind.

6. System zur Überwachung des elektrischen Zustands (100) nach Anspruch 5, wobei die Datenverarbeitungsanordnung (108) konfiguriert ist, um bereits vorhandene Analysedaten in ihren jeweiligen multivariaten Zellen mit den Analysedaten zu aktualisieren, um einen aktualisierten Durchschnitt und eine Standardabweichung für die erfassten Daten zu erzeugen.

7. System zur Überwachung des elektrischen Zustands (100) nach Anspruch 5, wobei die Datenverarbeitungsanordnung (108) konfiguriert ist, um durch Extrapolation und/oder Interpolation Daten für unausgefüllte multivariate Zellen aus benachbarten multivariaten Zellen zu berechnen, die mindestens basieren auf einem von: Spannungsmessungen, Strommessungen, Frequenzmessungen.

8. System zur Überwachung des elektrischen Zustands (100) nach einem der Ansprüche 1 bis 7, wobei die Datenverarbeitungsanordnung (108) konfiguriert ist, um Datenpunkte in den erfassten Daten basierend auf der berechneten Frequenz zu dezimieren, um eine Anzahl von relevanten Datenpunkten zum Erzeugen des sich zeitlich ändernden Fourier-Spektrums zu bestimmen.

9. System zur Überwachung des elektrischen Zustands (100) nach einem der Ansprüche 1 bis 8, wobei die elektrische Vorrichtung (102) mindestens eines aus Folgenden einschließt: einen synchronen Einphasen-Elektromotor, einen synchronen Mehrphasen-Elektromotor, einen synchronen Dreiphasen-Elektromotor, einen geschalteten Reluktanzmotor, einen geschalteten Schrittmotor, einen Gleichstrom-Elektromotor, einen Kompressor, eine Pumpe, einen Lüfter, einen Förderer, ein Rührwerk, einen Mixer, ein Gebläse, einen Mischer, einen Permanentmagnetmotor (PM-Motor), einen PM-Generator, einen Leistungstransformator, eine Klimaanlage, einen Ventilator, einen Ofen, ein Solarpanel, einen elektrischen synchronen Einphasen-Generator, einen elektrischen synchronen Mehrphasen-Generator, einen elektrischen synchronen Dreiphasen-Generator, einen elektrischen Gleichstrom-Generator, einen Permanentmagnet-Generator (PM-Generator).

10. System zur Überwachung des elektrischen Zustands (100) nach einem der Ansprüche 1 bis 9, wobei die Benutzeroberfläche (300) für die Benutzereingabe von Maschinenparametern konfiguriert ist, die die elektrische Vorrichtung (102) beschreiben, wobei die Maschinenparameter mindestens eines der Folgenden einschließen: eine generische Nennbetriebsspannung, einen generischen Nennbetriebsstrom, eine generische Nennversorgungsfrequenz, eine generische Nenndrehzahl, eine Anzahl von Flügeln an einem Laufrad der elektrischen Vorrichtung, Lagertypcodes der elektrischen Vorrichtung oder Riemenantriebsabmessungen der elektrischen Vorrichtung.

11. System zur Überwachung des elektrischen Zustands (100) nach einem der Ansprüche 1 bis 9, wobei die Benutzeroberfläche (300) für die Benutzereingabe von Maschinenparametern konfiguriert ist, die die Analyseart beschreiben, die durch die Datenverarbeitungsanordnung (108) auszuführen ist, wobei die Analyseart die Benutzereinstellung der zeitlichen Auflösung und einer Abtastdatenlänge ermöglicht.

12. System zur Überwachung des elektrischen Zustands (100) nach Anspruch 10, wobei die Benutzeroberfläche (300) konfiguriert ist, um eine Benutzereinstellung von Spannungs- und/oder Strommessungen von der elektrischen Vorrichtung (102) mit einer Abtastrate von bis zu 10 Megahertz zu ermöglichen.

13. System zur Überwachung des elektrischen Zustands (100) nach einem der vorstehenden Ansprüche, wobei die Benutzeroberfläche konfiguriert ist, um eine Benutzerauswahl zum Implementieren einer in der Datenverarbeitungsanordnung berechneten D-Q-Phasen- und A-B-Phasen-Transformation der erfassten Daten zu ermöglichen, wobei die D-Q-Phasen-Transformation dreiphasige Stator- und Rotorgrößen in einen einzelnen rotierenden Bezugsrahmen überträgt, um eine Wirkung von zeitlich variierenden Induktivitäten zu eliminieren, wobei die A-B-Phasen-Transformation sich auf eine mathematische Transformation bezieht, die implementiert wird, um eine Analyse eines dreiphasigen Stators und Rotors zu vereinfachen.

14. System zur Überwachung des elektrischen Zustands (100) nach einem der vorstehenden Ansprüche, wobei die Datenverarbeitungsanordnung (108) konfiguriert ist, um ein lineares Modell einer oder mehrerer Beziehungen zwischen Spannungs- und Stromsignalen zu erstellen, die von der elektrischen Vorrichtung (102) erhalten werden.

15. System zur Überwachung des elektrischen Zustands (100) nach einem de vorstehenden Ansprüche, wobei die Datenverarbeitungsanordnung (108) konfiguriert ist, um eine Analyse von mindestens einem von einem numerischen Algorithmus für eine Sub-Space-State-Space-Systemidentifikation (N4SID), einem Multivariable-Output-Error-State-Space-Algorithmus (MOESP), einem Past-Outputs-Multivariable-Output-Error-State-Space-Algorithmus (PO-MOESP) oder einer Canonical Variate Analysis (CVA) zu berechnen, um das Echtzeitmodell basierend auf den erfassten Daten zu erzeugen.

16. System zur Überwachung des elektrischen Zustands (100) nach einem der vorstehenden Ansprüche, wobei die Datenverarbeitungsanordnung (108) konfiguriert ist zum:
(i) Erzeugen eines linearen Modells, das die elektrische Vorrichtung (102) beschreibt;
(ii) Verwenden des linearen Modells, um ein Modell des vorhergesagten Stroms der elektrischen Vorrichtung (102) aus den von der elektrischen Vorrichtung (102) erhaltenen gemessenen Spannungen zu erstellen;
(iii) Vergleichen des Modells des vorhergesagten Stroms mit einem gemessenen Strom der elektrischen Vorrichtung (102), um einen Reststromdatenwert zu erzeugen;
(iv) Durchführen einer Fast-Fourier-Transformation (FFT) an dem Reststromdatenwert, um das sich zeitlich ändernde Fourier-Spektrum zu erzeugen;
(v) Identifizieren des mindestens einen lokalen Maximums auf dem sich zeitlich ändernden Fourier-Spektrum unter Verwendung einer Crawling-Technik, um eine Gesamtheit des sich zeitlich ändernden Fourier-Spektrums in lokale Maxima zu unterteilen, die an lokalen Minima miteinander verbunden sind, wobei die Crawling-Technik das mindestens eine lokale Maximum auf dem sich zeitlich ändernden Fourier-Spektrum identifiziert, indem sie einen Wert bestimmt, der in Richtung des mindestens einen lokalen Maximums steigt, oder einen Wert, der von dem mindestens einen lokalen Maximum weg fällt;
(vi) Identifizieren des signifikanten lokalen Maximums in Form eines Absolutwerts oder einer Anzahl von Standardabweichungen von einem Mittelwert; und
(vii) Kennzeichnen des signifikanten lokalen Maximums mit der Beschreibung des Phänomens in der Benutzeroberfläche zum Darstellen für den Benutzer.

17. Verfahren zum Verwenden des Systems zur Überwachung des elektrischen Zustands (100) nach einem der Ansprüche 1 bis 16, wobei das Verfahren umfasst:
(i) Verwenden der Sensoranordnung (106) des Systems zur Überwachung des elektrischen Zustands (100) zum zeitlichen Erfassen einer elektrischen Versorgung zu und/oder von der elektrischen Vorrichtung (102) und zum Erzeugen entsprechender erfasster Daten durch Verarbeiten der erfassten elektrischen Versorgung zu und/oder von der elektrischen Vorrichtung (102), wobei die erfassten Daten Informationen einschließen, die mindestens einer von einer Spannungs- oder einer Stromzufuhr zu und/oder von der elektrischen Vorrichtung (102) zugeordnet sind;
(ii) Verwenden des Datenprozessors der Datenverarbeitungsanordnung (108) des Systems zur Überwachung des elektrischen Zustands (100), um die erfassten Daten zu verarbeiten, um ein entsprechendes sich zeitlich änderndes Fourier-Spektrum zu erzeugen, das Signaloberwellenkomponenten für den Strom und/oder die Spannung einschließt, die oder der der elektrischen Vorrichtung (102) zugeführt und/oder von ihr abgeführt wird, und um zeitliche Änderungen bei den Größen und Frequenzen der Signaloberwellenkomponenten zu erzeugen, um Analysedaten zu erzeugen, die für den Betrieb der elektrischen Vorrichtung (102) repräsentativ sind; und
(iii) Konfigurieren der Benutzeroberfläche (300) zur Benutzereingabe von Eingabewerten zum Analysieren der Analysedaten und Verwenden des Datenprozessors zum Analysieren der Analysedaten basierend auf den Eingabewerten, um Informationen zu erhalten, die auf einen Betriebszustand der elektrischen Vorrichtung (102) hinweisen;
**dadurch gekennzeichnet, dass** das Verfahren ferner umfasst:
(iv) Betreiben der Datenverarbeitungsanordnung (108), um mindestens teilweise die Änderungen bei den Größen und Frequenzen der Signaloberwellenkomponenten herauszufiltern, die durch elektrische Verzerrungen verursacht werden, die in dem sich zeitlich ändernden Fourier-Spektrum vorhanden sind;
(v) Betreiben der Datenverarbeitungsanordnung (108), um mindestens ein lokales Maximums zu identifizieren, das einem Phänomen auf dem sich zeitlich ändernden Fourier-Spektrum entspricht, durch Analysieren des sich zeitlich ändernden Fourier-Spektrums, das basierend auf den erfassten Daten aufgetragen wird;
(vi) Betreiben der Datenverarbeitungsanordnung (108), um Positionen auf dem sich zeitlich ändernden Fourier-Spektrum zu berechnen, an denen das gleiche Phänomen auftritt, um eine Familie möglicher lokaler Maxima zu erzeugen;
(vii) Betreiben der Datenverarbeitungsanordnung (108) zum Identifizieren eines signifikanten lokalen Maximums aus der Familie möglicher lokaler Maxima, die dem Phänomen entsprechen, und zum Erzeugen der Analysedaten aus einer Größenordnung des signifikanten lokalen Maximums;
(viii) Betreiben der Datenverarbeitungsanordnung (108) zum Erzeugen eines Echtzeitmodells der elektrischen Vorrichtung (102) basierend auf den Analysedaten; und
(ix) Betreiben der Datenverarbeitungsanordnung (108) zum Zugreifen auf ein oder mehrere gespeicherte Modelle des Betriebs der elektrischen Vorrichtung (102) und Vergleichen des Echtzeitmodells mit dem einen oder den mehreren gespeicherten Modellen, um Informationen zu erzeugen, die auf einen Betriebszustand der elektrischen Vorrichtung (102) hinweisen.

18. Computerprogrammprodukt, umfassend ein nicht-transitorisches computerlesbares Speichermedium mit darauf gespeicherten computerlesbaren Anweisungen, um das System nach Anspruch 1 zu veranlassen, alle Schritte des Verfahrens nach Anspruch 17 auszuführen.

## Revendications

1. Système de surveillance d'état électrique (100) configuré pour surveiller
un dispositif électrique (102) lorsque le dispositif électrique (102) est en fonctionnement, dans lequel le système de surveillance d'état électrique (100) comprend :
le dispositif électrique (102) ;
un agencement de détection (106) ;
un agencement de traitement de données (108) ; et
une interface utilisateur (300) ;
dans lequel :
(i) l'agencement de détection (106) est configuré pour détecter temporellement une alimentation électrique vers et/ou depuis le dispositif électrique (102) et pour générer des données détectées par traitement de l'alimentation électrique détectée vers et/ou du dispositif électrique (102), dans lequel les données détectées comportent des informations associées à au moins l'une parmi une alimentation en tension ou une alimentation en courant vers et/ou depuis le dispositif électrique (102) ;
(ii) l'agencement de traitement de données (108) comprend un processeur de données qui est configuré pour traiter les données détectées pour générer un spectre de Fourier à changement temporel correspondant comportant des composantes harmoniques de signal pour au moins l'un parmi le courant ou la tension qui est fourni vers et/ou depuis le dispositif électrique (102) et pour traiter des changements temporels d'amplitudes et de fréquences des composantes harmoniques de signal pour générer des données d'analyse représentant le fonctionnement du dispositif électrique (102) ; et
(iii) l'interface utilisateur (300) est configurée pour une entrée d'utilisateur de saisie pour analyser les données d'analyse et le processeur de données est configuré pour analyser les données d'analyse en fonction de la saisie pour obtenir des informations indiquant un état de fonctionnement du dispositif électrique (102) ;
**caractérisé en ce que** l'agencement de traitement de données (108) est configuré pour :
filtrer au moins partiellement les changements d'amplitudes et de fréquences des composantes harmoniques de signal causées par une distorsion électrique présente dans le spectre de Fourier à changement temporel ;
identifier au moins un maximum local correspondant à un phénomène sur le spectre de Fourier à changement temporel en analysant le spectre de Fourier à changement temporel tracé en fonction des données détectées ;
calculer des emplacements sur le spectre de Fourier à changement temporel où le même phénomène apparaît pour créer une famille de maxima locaux possibles ;
identifier un maximum local significatif de la famille de maxima locaux possibles correspondant au phénomène et générer les données d'analyse à partir d'une amplitude du maximum local significatif ;
générer un modèle en temps réel du dispositif électrique (102) en fonction des données d'analyse ; et
accéder à un ou plusieurs modèles de fonctionnement stockés du dispositif électrique (102), et à comparer le modèle en temps réel avec les un ou plusieurs modèles stockés pour générer des informations indiquant un état de fonctionnement du dispositif électrique (102).

2. Système de surveillance d'état électrique (100) selon la revendication 1, dans lequel,
à l'étape (ii), le processeur de données est configuré pour utiliser l'au moins un parmi le courant ou la tension qui est fourni(e) vers et/ou depuis le dispositif électrique (102) pour calculer un courant résiduel ou une tension résiduelle, dans lequel la tension résiduelle calculée ou le courant résiduel est calculé en comparant un modèle de courant prédit avec un courant mesuré du dispositif électrique (102) pour générer des données de courant résiduelles ou des données de tension résiduelles.

3. Système de surveillance d'état électrique (100) selon la revendication 1 ou 2,
dans lequel l'agencement de traitement de données (108) est configuré pour calculer des différences de paramètres entre le modèle en temps réel et les un ou plusieurs modèles stockés, et pour générer un modèle prédictif décrivant les différences de paramètres pour générer les informations indiquant un état de fonctionnement du dispositif électrique (102).

4. Système de surveillance d'état électrique (100) selon la revendication 3, dans lequel
l'agencement de traitement de données (108) est configuré pour générer une ou plusieurs alertes concernant :
(a) l'utilisation d'énergie et/ou les tendances de génération du dispositif électrique (102) ;
(b) la génération de dioxyde de carbone (équivalent) étant provoquée et/ou enregistrée par le dispositif électrique (102) ;
(c) la maintenance, le remplacement ou la réparation du dispositif électrique (102) ; et
(d) un état d'isolation du dispositif électrique (102).

5. Système de surveillance d'état électrique (100) selon l'une quelconque des revendications 1 à 4, dans lequel l'interface utilisateur (300) est configurée pour une entrée d'utilisateur de paramètres définis par l'utilisateur pour générer une plage de cellules multivariées dans une base de données (202) du système de surveillance d'état électrique (100) et l'agencement de traitement de données (108) est configuré pour mettre à jour les données détectées du dispositif électrique (102) dans leurs cellules multivariées respectives, dans lequel les cellules multivariées stockent le spectre de Fourier à changement temporel associé aux données détectées et aux un ou plusieurs modèles stockés associés au dispositif électrique (102).

6. Système de surveillance d'état électrique (100) selon la revendication 5, dans lequel l'agencement de traitement de données (108) est configuré pour mettre à jour des données d'analyse préexistantes dans leurs cellules multivariées respectives avec les données d'analyse pour générer une moyenne mise à jour et un écart type pour les données détectées.

7. Système de surveillance d'état électrique (100) selon la revendication 5, dans lequel l'agencement de traitement de données (108) est configuré pour calculer par extrapolation et/ou interpolation des données pour des cellules multivariées non peuplées à partir de cellules multivariées voisines qui reposent sur au moins l'un parmi : des mesures de tension, des mesures de courant, des mesures de fréquence.

8. Système de surveillance d'état électrique (100) selon l'une quelconque des revendications 1 à 7, dans lequel l'agencement de traitement de données (108) est configuré pour décimer des points de données dans les données détectées en fonction de la fréquence calculée pour déterminer un nombre de points de données pertinents pour générer le spectre de Fourier à changement temporel.

9. Système de surveillance d'état électrique (100) selon l'une quelconque des revendications 1 à 8, dans lequel le dispositif électrique (102) comporte au moins l'un parmi : un moteur électrique monophasé synchrone, un moteur électrique polyphasé synchrone, un moteur électrique triphasé synchrone, un moteur à réluctance commutée, un moteur pas à pas commuté, un moteur électrique à courant continu, un compresseur, une pompe, une soufflante, un transporteur, un agitateur, un mélangeur, un ventilateur, un mélangeur, un moteur à aimants permanents (PM), un générateur PM, un transformateur de puissance, un climatiseur, un ventilateur, un four, un panneau solaire, un générateur électrique à phase synchrone, un générateur électrique multiphasique synchrone, un générateur électrique synchrone triphasé un générateur électrique CC, un générateur à aimants permanents (PM).

10. Système de surveillance d'état électrique (100) selon l'une quelconque des revendications 1 à 9, dans lequel l'interface utilisateur (300) est configurée pour une entrée d'utilisateur de paramètres de machine décrivant le dispositif électrique (102), dans lequel les paramètres de machine comprennent au moins l'un parmi : une tension de fonctionnement nominale générique, un courant de fonctionnement nominal générique, une fréquence d'alimentation nominale générique, une vitesse de rotation nominale générique, un nombre d'aubes sur un impulseur du dispositif électrique, portant des codes de type du dispositif électrique ou des dimensions d'entraînement de bande du dispositif électrique.

11. Système de surveillance d'état électrique (100) selon l'une quelconque des revendications 1 à 9, dans lequel l'interface utilisateur (300) est configurée pour une entrée d'utilisateur de paramètres de machine décrivant un type d'analyse à exécuter par l'agencement de traitement de données (108), dans lequel le type d'analyse permet un réglage d'utilisateur de résolution temporelle et une longueur d'échantillon de données de détection.

12. Système de surveillance d'état électrique (100) selon la revendication 10, dans lequel l'interface utilisateur (300) est configurée pour permettre un réglage utilisateur des lectures de tension et/ou de courant depuis le dispositif électrique (102) à un taux d'échantillonnage allant jusqu'à 10 Mega Hertz.

13. Système de surveillance d'état électrique (100) selon l'une quelconque des revendications précédentes, dans lequel l'interface utilisateur est configurée pour permettre une sélection par l'utilisateur pour mettre en oeuvre une phase D-Q et une transformation de phase A-B, calculées dans l'agencement de traitement de données, des données détectées, dans lequel la transformation de phase D-Q transfère des quantités d'un stator et d'un rotor triphasé dans un seul cadre de référence rotatif pour éliminer un effet des inductances variant dans le temps, dans lequel la transformation de phase A-B fait référence à une transformation mathématique qui est mise en oeuvre pour simplifier une analyse d'un stator et d'un rotor triphasé.

14. Système de surveillance d'état électrique (100) selon l'une quelconque des revendications précédentes, dans lequel l'agencement de traitement de données (108) est configuré pour créer un modèle linéaire d'une ou plusieurs relations entre des signaux de tension et de courant obtenus à partir du dispositif électrique (102).

15. Système de surveillance d'état électrique (100) selon l'une quelconque des revendications précédentes, dans lequel l'agencement de traitement de données (108) est configuré pour calculer une analyse d'au moins l'un parmi un algorithme numérique pour une identification de système d'état de sous-espace (N4SID), un algorithme d'espace d'état d'erreur de sortie multivariable (MOESP), un algorithme d'espace d'état d'erreur de sortie multivariable des sorties passées (PO-MOESP) ou une analyse canonique des variables (CVA) pour générer le modèle de temps réel en fonction des données détectées.

16. Système de surveillance d'état électrique (100) selon l'une quelconque des revendications précédentes, dans lequel l'agencement de traitement de données (108) est configuré pour :
(i) générer un modèle linéaire décrivant le dispositif électrique (102) ;
(ii) utiliser le modèle linéaire pour créer un modèle de courant prédit du dispositif électrique (102) à partir de tensions mesurées obtenues à partir du dispositif électrique (102) ;
(iii) comparer le modèle de courant prédit avec un courant mesuré du dispositif électrique (102) pour créer des données de courant résiduel ;
(iv) effectuer une transformée de Fourier rapide (FFT) sur les données de courant résiduel pour créer le spectre de Fourier à changement temporel ;
(v) identifier l'au moins un maximum local sur le spectre de Fourier à changement temporel à l'aide d'une technique de reptation pour diviser la totalité du spectre de Fourier à changement temporel en maxima locaux joints les uns aux autres à des minima locaux, dans lequel la technique de reptation identifie l'au moins un maximum local sur le spectre de Fourier à changement temporel en déterminant une valeur qui augmente vers l'au moins un maximum local ou une valeur qui diminue de l'au moins un maximum local ;
(vi) identifier le maximum local significatif en termes de valeur absolue ou de nombre d'écarts types à partir d'une valeur moyenne ; et
(vii) marquer le maximum local important par la description de phénomène dans l'interface utilisateur aux fins de présentation à l'utilisateur.

17. Procédé d'utilisation du système de surveillance d'état électrique (100) selon l'une quelconque des revendications 1 à 16, dans lequel le procédé comprend :
(i) l'utilisation de l'agencement de détection (106) du système de surveillance d'état électrique (100) pour détecter temporellement une alimentation électrique vers et/ou depuis le dispositif électrique (102) et pour générer des données détectées correspondantes en traitant l'alimentation électrique détectée vers et/ou depuis le dispositif électrique (102), dans lequel les données détectées comportent des informations associées à au moins l'une parmi une alimentation en tension ou une alimentation en courant vers et/ou depuis le dispositif électrique (102) ;
(ii) l'utilisation du processeur de données de l'agencement de traitement de données (108) du système de surveillance d'état électrique (100), pour traiter les données détectées pour générer un spectre de Fourier à changement temporel correspondant comportant des composantes harmoniques de signal pour au moins l'un parmi le courant ou la tension qui est fourni(e) vers et/ou depuis le dispositif électrique (102) et pour traiter des changements temporels d'amplitudes et de fréquences des composantes harmoniques de signal pour générer des données d'analyse représentant le fonctionnement du dispositif électrique (102) ; et
(iii) la configuration de l'interface utilisateur (300) pour l'entrée d'utilisateur de saisie pour analyser les données d'analyse et l'utilisation du processeur de données pour analyser les données d'analyse en fonction de la saisie pour obtenir des informations indiquant un état de fonctionnement du dispositif électrique (102) ;
**caractérisé en ce que** le procédé comprend en outre :
(iv) le fonctionnement de l'agencement de traitement de données (108) pour filtrer au moins partiellement les changements d'amplitudes et de fréquences des composantes harmoniques de signal causées par une distorsion électrique présente dans le spectre de Fourier à changement temporel ;
(v) le fonctionnement de l'agencement de traitement de données (108) pour identifier au moins un maximum local correspondant à un phénomène sur le spectre de Fourier à changement temporel en analysant le spectre de Fourier à changement temporel qui sont tracés en fonction des données détectées ;
(vi) le fonctionnement de l'agencement de traitement de données (108) pour calculer des emplacements sur le spectre de Fourier à changement temporel où le même phénomène apparaît pour créer une famille de maxima locaux possibles ;
(vii) le fonctionnement de l'agencement de traitement de données (108) pour identifier un maximum local significatif de la famille de maxima locaux possibles correspondant au phénomène et pour générer les données d'analyse à partir d'une amplitude du maximum local significatif ;
(viii) le fonctionnement de l'agencement de traitement de données (108) pour générer un modèle en temps réel du dispositif électrique (102) en fonction des données d'analyse ; et
(ix) le fonctionnement de l'agencement de traitement de données (108) pour accéder à un ou plusieurs modèles de fonctionnement stockés du dispositif électrique (102), et pour comparer le modèle en temps réel avec les un ou plusieurs modèles stockés pour générer des informations indiquant un état de fonctionnement du dispositif électrique (102).

18. Produit programme informatique comprenant un support de stockage lisible par ordinateur non transitoire comportant des instructions lisibles par ordinateur stockées sur celui-ci pour amener le système selon la revendication 1 à réaliser toutes les étapes du procédé selon la revendication 17.
